# EUROPEAN PATENT APPLICATION

(11) **EP 1 898 448 A1**
(43) Date of publication of application: **12.03.2008**
(21) Application number: 06767590.0
(22) Date of filing: 29.06.2006
(51) Int. Cl.: H01L 21/027, G03F 7/20

(54) **EXPOSURE APPARATUS, SUBSTRATE PROCESSING METHOD, AND DEVICE PRODUCING METHOD**

(30) Priority: 29.06.2005 JP 2005190254; 17.04.2006 JP 2006113478
(71) Applicant: NIKON CORPORATION, Tokyo 100-8831 (JP)
(72) Inventor: FUJIWARA, Tomoharu, NIKON CORPORATION, Tokyo 100-8331 (JP); NAKANO, Katsushi, NIKON CORPORATION, Tokyo 100-8331 (JP)
(74) Representative: HOFFMANN EITLE
(86) International application number: PCT/JP2006/312973
(87) International publication number: WO 2007/001045

(57) **Abstract**

An exposure apparatus (EX) includes a detector (60) which detects a defect in a thin film (Rg, Tc) formed on a substrate (P). When the detector is provided for liquid immersion exposure in which the substrate (P) is exposed through liquid (LQ), outflow of the liquid due to by any defect in the thin film (Rg, Tc) is detected before the liquid outflows, thereby suppressing reduction in throughput in producing device and preventing any problem or inconvenience from occurring in the exposure apparatus.

## Description

### BACKGROUND OF THE INVENTION

### Field of the Invention:

The present invention relates to an exposure apparatus which exposes a substrate by radiating an exposure light onto the substrate, a method for processing a substrate, and a method for producing a device.

### Description of the Related Art:

In relation to the exposure apparatus to be used in the photolithography step, a liquid immersion exposure apparatus is contrived, in which a liquid immersion area of a liquid is formed on a substrate, and the substrate is exposed through the liquid, as disclosed in International Publication No. 99/49504.

### DISCLOSURE OF THE INVENTION

### Task to Be Solved by the Invention:

In order to form the liquid immersion area of the liquid on the substrate satisfactorily, it is necessary that a liquid contact surface of the substrate, which makes contact with the liquid, should be in a desired state. For example, if a film of a photosensitive material or the like, formed on the substrate, is not formed in the desired state, the following inconvenience or problem arises. That is, for example, the liquid immersion area is not formed satisfactorily, the liquid outflows from the surface of the substrate, and/or the exposure cannot be performed on the substrate with a desired image of the pattern.
Consequently, the productivity (throughput) in producing the device is lowered.

Further, the following possibility arises. That is, the film is not formed on the substrate in the desired state, for example, and a part of the film may be exfoliated or removed from the substrate. If any part of the film is exfoliated, the part of the exfoliated film becomes a foreign matter, and may possibly adhere onto the substrate and/or enter into and mix with the liquid. If the substrate is exposed in a state that the foreign matter is present, the following possibility arises. That is, any inconvenience arises, for example, such that the pattern to be formed on the substrate has any defect, and the throughput in producing the device is lowered.

The present invention has been made taking the foregoing circumstances into consideration, an object of which is to provide an exposure apparatus, a method for processing a substrate, and a method for producing a device, in which the substrate can be exposed satisfactorily, and it is possible to suppress the decrease in the throughput in producing the device.

### Solution for the Task:

In order to achieve the object as described above, the present invention adopts the following constructions corresponding to respective drawings as illustrated in embodiments. However, parenthesized symbols affixed to respective elements merely exemplify the elements by way of example, with which it is not intended to limit the respective elements.

According to a first aspect of the present invention, there is provided an exposure apparatus (EX) which exposes a substrate (P) by radiating an exposure light (EL) onto the substrate (P) on which a thin film (Rg, Tc) is formed, the exposure apparatus comprising a detector (60) which detects a state of formation of the thin film (Rg, Tc) on the substrate (P).

According to the first aspect of the present invention, the detector or detecting device is provided to detect the state of formation of the thin film on the substrate. Therefore, it is possible to adopt a measure in order to suppress the decrease in the throughput in producing the device by using a result of the detection performed by the detector.

According to a second aspect of the present invention, there is provided an exposure apparatus (EX) which exposes a substrate (P) by radiating an exposure light (EL) onto the substrate (P) through a liquid (LQ), the exposure apparatus comprising a detector (40, 60') which detects a state of an edge of the substrate (P).

According to the second aspect of the present invention, the detector or detecting device is provided to detect the state of the edge of the substrate. Therefore, it is possible to adopt a measure in order to suppress the decrease in the throughput in producing the device by using a result of the detection performed by the detector.

According to a third aspect of the present invention, there is provided an exposure apparatus (EX) which exposes a substrate by radiating, through a liquid (LQ), an exposure light (EL) onto the substrate (P) on which a thin film (Rg, Tc) is formed, the exposure apparatus comprising an optical system (IL) which is arranged in an optical path for the exposure light (EL); and a detector (40, 60') which detects a defect of the thin film (Rg, Tc) of the substrate (P) to which the liquid (EL) is provided.

According to the third aspect of the present invention, the detector or detecting device is provided to detect the defect of the thin film (Rg, Tc) of the substrate (P) to which the liquid (EL) is provided. Therefore, it is possible to adopt a measure in order to suppress the decrease in the throughput in producing the device and any trouble or inconvenience of the exposure apparatus, by using a result of the detection performed by the detector.

According to a fourth aspect of the present invention, there is provided a method for producing a device, comprising using the exposure apparatus (EX) as defined in any one of the aspects described above. According to the fourth aspect of the present invention, it is possible to produce the device at a satisfactory throughput.

According to a fifth aspect of the present invention, there is provided a method for processing a substrate, on which a film (Rg, Tc) is formed, for exposure-processing the substrate (P), the method comprising holding the substrate (P) by a substrate-holding member (4); radiating an exposure light (EL) through a liquid (LQ) onto the substrate (P) held by the substrate-holding member (4) to exposure-process the substrate (P); and detecting a state of the film (Rg, Tc) of the substrate (P) before radiating the exposure light (EL) onto the substrate (P).

According to the fifth aspect of the present invention, it is possible to adopt a measure in order to suppress the decrease in the throughput in producing the device, by using a result of the detection of the state of the film of the substrate.

According to a sixth aspect of the present invention, there is provided a method for processing a substrate to be exposed through a liquid, the method comprising forming (SA0) a thin film on the substrate; inspecting (SA2, SB2, SC3) a defect of the thin film; supplying (SB4, SC8) the liquid onto the thin film; and radiating (SA5, SB5, SC9) an exposure light onto the substrate through the supplied liquid.

According to the sixth aspect of the present invention, any defect of the thin film (Rg, Tc) formed on the substrate is previously detected before the substrate (P) is exposed through the liquid. Therefore, it is possible to suppress the decrease in the throughput in producing the device, and it is possible to avoid any trouble of the exposure apparatus beforehand.

According to a seventh aspect of the present invention, there is provided a method for producing a device, comprising exposure-processing a substrate by using the method for processing the substrate as defined in any one of the aspects described above; developing the exposed substrate; and processing the developed substrate. According to the seventh aspect of the present invention, it is possible to produce the device at a satisfactory throughput.

### Effect of the Invention:

According to the present invention, it is possible to expose the substrate satisfactorily, it is possible to suppress the decrease in the throughput in producing the device, and it is possible to avoid the trouble of the exposure apparatus beforehand.

### BRIEF DESCRIPTION OF THE DRAWINGS

Fig. 1 is a schematic arrangement view of an exposure apparatus according to a first embodiment.
Fig. 2 is a schematic arrangement view of a body of the exposure apparatus.
Fig. 3 is a sectional view of an exemplary substrate on which a thin film is formed.
Fig. 4 is a schematic arrangement view of a detector according to the first embodiment.
Fig. 5 is a flow chart illustrating an exposure method according to the first embodiment.
Fig. 6 is a flow chart illustrating an exposure method according to a second embodiment.
Fig. 7 is a schematic arrangement view of a detector according to the second embodiment.
Fig. 8 is a schematic arrangement view of an exposure apparatus according to a third embodiment.
Fig. 9 is a flow chart illustrating an exposure method according to the third embodiment.
Fig. 10 schematically shows a situation in which an edge detecting system detects a state of an edge of the substrate.
Fig. 11 is a schematic arrangement view of an exposure apparatus according to the third embodiment.
Fig. 12 shows a state that a liquid immersion area is formed on the edge of the substrate.
Fig. 13 is a schematic arrangement view of an exposure apparatus according to a fourth embodiment.
Fig. 14 schematically illustrates an example of the operation of the exposure apparatus provided with a plurality of substrate stages.
Fig. 15 is a schematic arrangement view of an exposure apparatus according to a fifth embodiment.
Fig. 16 schematically shows a detector according to the fifth embodiment.
Fig. 17 shows a flow chart illustrating exemplary steps of producing a microdevice.

### Legend of reference numerals:

1: liquid immersion mechanism, 4: substrate stage, 5: second substrate stage, 4H: substrate holder, 7: controller, 8: storage device, 30: focus/leveling-detecting system, 31: light-emitting system, 32: light-receiving system, 40: mark-detecting system, 50: temperature-adjusting device, 60: detector, 61: light-emitting system, 62: light-receiving system, EL: exposure light, EX: exposure apparatus, H: transport device, LQ: liquid, P: substrate, Rg: first film, S: body of the exposure apparatus, SP1: first area, SP2: second area, Tc: second film, W: base material.

### BEST MODE FOR CARRYING OUT THE INVENTION

Embodiments of the present invention will be explained below with reference to the drawings. However, the present invention is not limited thereto. In the following description, a XYZ rectangular coordinates system is defined, and the positional relationship between respective members is explained with reference to the XYZ rectangular coordinates system. An X axis direction is a predetermined direction in a horizontal plane, a Y axis direction is a direction which is perpendicular to the X axis direction in the horizontal plane, and a Z axis direction is a direction which is perpendicular to each of the X axis direction and the Y axis direction (i.e., a vertical direction). Directions of rotation (inclination) about the X axis, the Y axis, and the Z axis are designated as θx, θY, and θZ directions respectively.

### First Embodiment

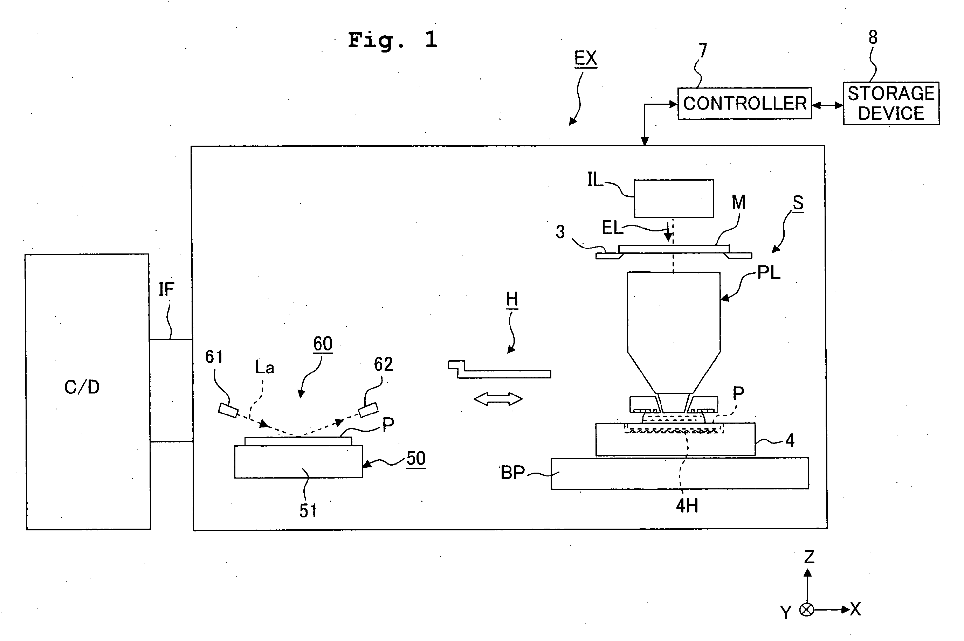

A first embodiment will be explained. Fig. 1 shows a schematic arrangement view of an exposure apparatus EX according to the first embodiment. With reference to Fig. 1, the exposure apparatus EX includes a body S of the exposure apparatus (exposure-apparatus body S) in which the exposure light EL is irradiated onto the substrate P to exposure-process the substrate P, a transport device H which transports the substrate P, a controller 7 which controls the operation of the entire exposure apparatus EX, and a storage device 8 which stores various types of information in relation to the exposure process. The exposure-apparatus body S includes a mask stage 3 which is movable while holding the mask M, a substrate stage 4 which is movable while holding the substrate P which is irradiated with the exposure light EL, an illumination optical system IL which illuminates, with the exposure light EL, the mask M held by the mask stage 3, and a projection optical system PL which projects, onto the substrate P, an image of a pattern (pattern image) of the mask M illuminated with the exposure light EL. The substrate referred to herein includes those obtained by coating, on a base material such as a semiconductor wafer, various films including, for example, a photosensitive material (photoresist) and a protective film (top coat film). The mask includes a reticle formed with a device pattern to be subjected to the reduction projection onto the substrate. In this embodiment, a transmissive type mask is used as the mask. However, it is also possible to use a reflective type mask.

A coater/developer apparatus C/D, which includes a coating device which forms the thin film on the substrate P and a developer device which develops the substrate P after the exposure process, is connected to the exposure apparatus EX via an interface IF. As described later on, the thin film, which is formed on the substrate P, includes, for example, a film made of the photosensitive material and formed on the base material such as the semiconductor wafer, and a film called "top coat film" for covering the film made of the photosensitive material. The transport device H is capable of transporting, to the substrate stage 4 of the exposure-apparatus body S, the substrate P, loaded via the interface IF from the coater/developer apparatus C/D (coating device), before the substrate P is subjected to the exposure process. Further, the transport device H is capable of transporting the substrate P, after the substrate P has been subjected to the exposure process, from the exposure-apparatus body S via the interface IF to the coater/developer apparatus C/D (developer device).

The exposure apparatus EX further includes a detector 60 which detects the state of formation of the thin film on the substrate P. The detector 60 detects the state of formation of the thin film on the substrate P, loaded from the coater/developer apparatus C/D (coating device) to the exposure apparatus EX, before the substrate P is subjected to the exposure process. The detector 60 is provided on a transport path of the transport device H.

A temperature-adjusting device 50, which adjusts the temperature of the substrate P before the exposure process and loaded from the coater/developer apparatus C/D into the exposure apparatus EX, is provided on a transport path of the transport device H. The temperature-adjusting device 50 is provided with a temperature-adjusting holder 51 which holds the back surface of the substrate P. The detector 60 is provided in the vicinity of the temperature-adjusting device 50. The transport device H is capable of loading the substrate P into the temperature-adjusting holder 51 of the temperature-adjusting device 50, and it is capable of unloading the substrate P from the temperature-adjusting holder 51. The detector 60 detects the state of formation of the thin film of the substrate P loaded or transported into the temperature-adjusting device 50 by the transport device H. The detector 60 has a light-emitting system 61 which emits or radiates a detecting light La onto the substrate P held by the temperature-adjusting holder 51, and a light-receiving system 62 which is capable of receiving the detecting light La via the substrate P. The light-emitting system 61 emits the detecting light La onto a surface of the substrate P in an oblique direction. The light-receiving system 62 is capable of receiving the detecting light La which is radiated onto the surface of the substrate P by the light-emitting system 61 and which is reflected by the surface.

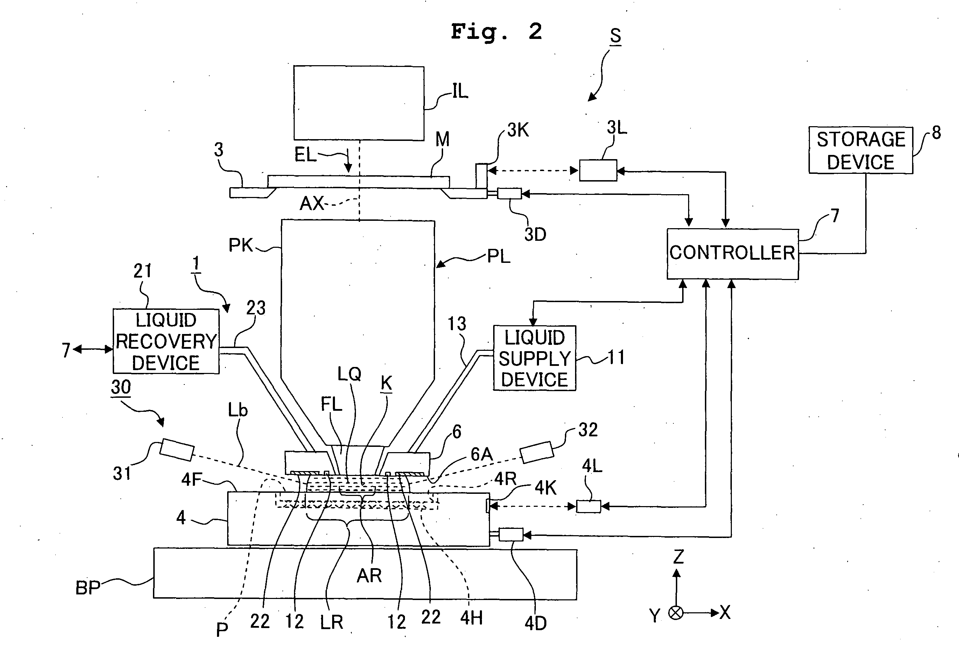

Next, the exposure-apparatus body S will be explained with reference to Fig. 2. The illumination optical system IL illuminates a predetermined illumination area on the mask M with the exposure light EL having a uniform illuminance distribution. The exposure light EL radiated from the illumination optical system IL includes, for example, emission lines (g-ray, h-ray, i-ray) radiated, for example, from a mercury lamp, far ultraviolet light beams (DUV light beams) such as the KrF excimer laser beam (wavelength: 248 nm), and vacuum ultraviolet light beams (VUV light beams) such as the ArF excimer laser beam (wavelength: 193 nm) and the F₂ laser beam (wavelength: 157 nm). In this embodiment, the ArF excimer laser beam is used.

The mask stage 3 is movable in the X axis direction, the Y axis direction, and the θZ direction in a state that the mask M is held, in accordance with the driving of a mask stage-driving device 3D including an actuator such as a linear motor. The position information about the mask stage 3 (as well as the mask M) is measured by a laser interferometer 3L. The laser interferometer 3L measures the position information about the mask stage 3 by using a movement mirror 3K fixedly secured on the mask stage 3. The controller 7 drives the mask stage-driving device 3D based on the result of the measurement performed by the laser interferometer 3L to control the position of the mask M held by the mask stage 3. The movement mirror 3K is not limited to only a plane mirror, and may include a corner cube (retroreflector). Alternatively, for example, it is also allowable to use a reflecting surface formed by mirror-finishing an end surface (side surface) of the mask stage 3, instead of the movement mirror 3K fixedly secured to the mask stage 3.

The projection optical system PL projects, at a predetermined projection magnification, the image of the pattern of the mask M onto the substrate P. The projection optical system PL has a plurality of optical elements. The optical elements are held by a barrel PK. In this embodiment, the projection optical system PL is the reduction system having the projection magnification which is, for example, 1/4, 1/5, or 1/8. The projection optical system PL may be any one of the reducing system, the 1x magnification system, and the magnifying system. The projection optical system PL may be any one of the dioptric system including no catoptric optical element, the catoptric system including no dioptric optical element, and the catadioptric system including dioptric and catoptric optical elements. The projection optical system PL may form any one of the inverted image and the erecting image.

The substrate stage 4 has a substrate holder 4H which holds the substrate P, and is movable while holding the substrate P in the substrate holder 4H on a base member BP. The substrate holder 4H is arranged in a recess 4R provided on the substrate stage 4. An upper surface 4F of the substrate stage 4 except for the recess 4R is a flat surface which has an approximately same height as that of (is flush with) the surface of the substrate P held by the substrate holder 4H. It is also allowable that any difference in height is present between the surface of the substrate P held by the substrate holder 4H and the upper surface 4F of the substrate stage 4. Only a part of the upper surface 4F of the substrate stage 4, for example, only a predetermined area surrounding the substrate P may have an approximately same height as that of the surface of the substrate P. Further, the substrate holder 4H may be formed integrally with a part of the substrate stage 4. However, in this embodiment, the substrate holder 4H and the substrate stage 4 are constructed distinctly or separately. The substrate holder 4H is fixed to the recess 4R, for example, by the vacuum attraction.

The substrate stage 4 is movable in the directions of six degrees of freedom of the X axis, Y axis, Z axis, θX, θY, and θZ directions in a state that the substrate P is held, in accordance with the driving of the substrate stage-driving device 4D including an actuator such as a linear motor. The position information about the substrate stage 4 (as well as the substrate P) is measured by a laser interferometer 4L. The laser interferometer 4L measures the position information of the substrate stage 4 in relation to the X axis, Y axis, and θZ directions by using a movement mirror 4K fixedly secured to the substrate stage 4. The surface position information about the surface of the substrate P (position information in relation to the Z axis, θX, and θY directions) is detected by a focus/leveling-detecting system 30. The focus/leveling-detecting system 30 has a light-emitting system 31 which radiates a detecting light Lb onto the substrate P held by the substrate holder 4H, and a light-receiving system 32 which is capable of receiving the detecting light Lb via the substrate P. The light-emitting system 31 emits the detecting light Lb onto the surface of the substrate P in an oblique direction. The light-receiving system 32 is capable of receiving the detecting light Lb which is radiated onto the surface of the substrate P by the light-emitting system 31 and which is reflected by the surface. The controller 7 drives the substrate stage-driving device 4D based on the result of the measurement performed by the laser interferometer 4L and the result of the detection performed by the focus/leveling-detecting system 30 to control the position of the substrate P held by the substrate stage 4. It is also allowable that the laser interferometer 4L is capable of measuring the information about the position of the substrate stage 4 in the Z axis direction and the rotation in the θX and θY directions as well, of which details thereof are disclosed, for example, in Published Japanese Translation of PCT International Publication for Patent Application No. 2001-510577 (corresponding to International Publication No. 1999/28790). A reflecting surface, which is formed, for example, by mirror-finishing a part (for example, a side surface) of the substrate stage 4, may be used in place of the movement mirror 4K fixedly secured to the substrate stage 4. The focus/leveling-detecting system 30 detects the information about the inclination (angle of rotation) of the substrate P in the θX and θY directions by measuring the position information about the substrate P in the Z axis direction at a plurality of measuring points respectively. In this embodiment, at least a part or parts of the plurality of measuring points are defined in a liquid immersion area LR (or in a projection area AR). However, it is also allowable that all of the measuring points are defined at the outside of the liquid immersion area LR. Further, for example, when the laser interferometer 4L is capable of measuring the position information about the substrate P in the Z axis, θX, and θY directions, it is also allowable that the focus/leveling-detecting system 30 is not provided so that the position information in the Z axis direction is measurable during the exposure operation for the substrate P. The position of the substrate P in relation to the Z axis, θX, and θY directions may be controlled by using the result of the measurement performed by the laser interferometer 4L at least during the exposure operation. In this case, the focus/leveling-detecting system 30 is provided, for example, for a measuring station which will be described later on.

The exposure apparatus EX (exposure-apparatus body S) of the embodiment of the present invention is a liquid immersion exposure apparatus in which the liquid immersion method is applied in order that the exposure wavelength is substantially shortened to improve the resolution and the depth of focus is substantially widened. The exposure apparatus EX includes a liquid immersion mechanism 1 which fills, with the liquid LQ, an optical path space K for the exposure light EL on a side of the image plane (image-plane side) of the projection optical system PL to form the liquid immersion area LR of the liquid LQ on the substrate P. The liquid immersion mechanism 1 fills, with the liquid LQ, the optical path space K between the substrate P which is held by the substrate stage 4 and the final optical element FL, of the projection optical system PL, which is provided at the position opposite to or facing the substrate P and via which the exposure light EL passes. In this embodiment, only the final optical element FL which is closest, among the plurality of optical elements of the projection optical system PL, to the image plane of the projection optical system PL makes contact with the liquid LQ in the optical path space K.

The liquid immersion mechanism 1 is provided with a nozzle member 6 which is provided in the vicinity of the optical path space K and which has a supply port 12 for supplying the liquid LQ to the optical path space K and a recovery port 22 for recovering the liquid LQ from the optical path space K; a liquid supply device 11 which supplies the liquid LQ via a supply tube 13 and the supply port 12 of the nozzle member 6; and a liquid recovery device 21 which recovers the liquid LQ via the recovery port 22 of the nozzle member 6 and a recovery tube 23. The nozzle member 6 is an annular member which is provided to surround the final optical element FL of the projection optical system PL. In this embodiment, the supply port 12 for supplying the liquid LQ and the recovery port 22 for recovering the liquid LQ are formed on a lower surface 6A of the nozzle member 6. The lower surface 6A of the nozzle member 6 is opposite to or facing the surface of the substrate P held or retained by the substrate stage 4. A flow passage connecting the supply port 12 and the supply tube 13 and a flow passage connecting the recovery port 22 and the recovery tube 23 are formed in the nozzle member 6. The supply port 12 is provided, on the lower surface 6A of the nozzle member 6, as a plurality of supply ports 12 arranged at a plurality of predetermined positions respectively to surround the final optical element FL of the projection optical system PL (optical path space K). On the other hand, the recovery port 22 is provided, on the lower surface 6A of the nozzle member 6, at the outside of the supply ports 12 with respect to the final optical element FL. The recovery port 22 is provided in an annular form to surround the final optical element FL and the supply ports 12. In this embodiment, for example, a mesh member made of titanium or a porous member made of ceramics is arranged in the recovery port 22. The operations of the liquid supply device 11 and the liquid recovery device 21 are controlled by the controller 7. The liquid supply device 11 is capable of feeding out the liquid LQ which is clean and temperature-adjusted. The liquid recovery device 12, which includes, for example, a vacuum system, is capable of recovering the liquid LQ. The structure of the liquid immersion mechanism 1 including, for example, the nozzle member 6 and the like is not limited to the structure described above. It is possible to use those described, for example, in European Patent Publication No. 1420298 and International Publication Nos. 2004/055803, 2004/057590, and 2005/029559. Specifically, in this embodiment, the lower surface of the nozzle member 6 is defined at the approximately same height (Z position) as that of the lower end surface (light exit surface) of the projection optical system PL. However, for example, the lower surface 6A of the nozzle member 6 may be defined at a position shifted toward the image plane (toward the substrate) than the lower end surface of the projection optical system PL. In this case, a part (lower end surface) of the nozzle member 6 may be provided to extend up to a position under or below the projection optical system PL (final optical element FL) so that the exposure light EL is not shielded. In this embodiment, the supply ports 12 are provided on the lower surface 6A of the nozzle member 6. However, for example, the supply ports 12 may be provided on an inner side surface (inclined surface) of the nozzle member 6 opposite to or facing the side surface of the final optical element FL of the projection optical system PL.

The exposure apparatus EX (exposure-apparatus body S) uses the liquid immersion mechanism 1, at least during the period in which the pattern image of the mask M is projected onto the substrate P, to fill the optical path space K for the exposure light EL with the liquid LQ and to form the liquid immersion area LR on the substrate P. The exposure apparatus EX projects the pattern image of the mask M onto the substrate P by radiating the exposure light EL passing through the mask M onto the substrate P via the projection optical system PL and the liquid LQ of the liquid immersion area LR formed on the substrate P. The exposure apparatus EX of this embodiment adopts the local liquid immersion system wherein the liquid LQ, filled in the optical path space K, forms the liquid immersion area LR of the liquid LQ locally in a partial area, on the substrate P, including the projection area AR of the projection optical system PL, the liquid immersion area LR being larger than the projection area AR and smaller than the substrate P. The controller 7 controls the liquid immersion mechanism 1 to concurrently perform the liquid supply operation by the liquid supply device 11 and the liquid recovery operation by the liquid recovery device 21, so that the optical path space K is filled with the liquid LQ to locally form the liquid immersion area LR of the liquid LQ in the partial area on the substrate P.

In this embodiment, pure or purified water is used as the liquid LQ. Not only the ArF excimer laser beam but also the emission line (g-ray, h-ray, i-ray) radiated, for example, from a mercury lamp and the far ultraviolet light beam (DUV light beam) such as the KrF excimer laser beam (wavelength: 248 nm) are also transmissive through pure water.

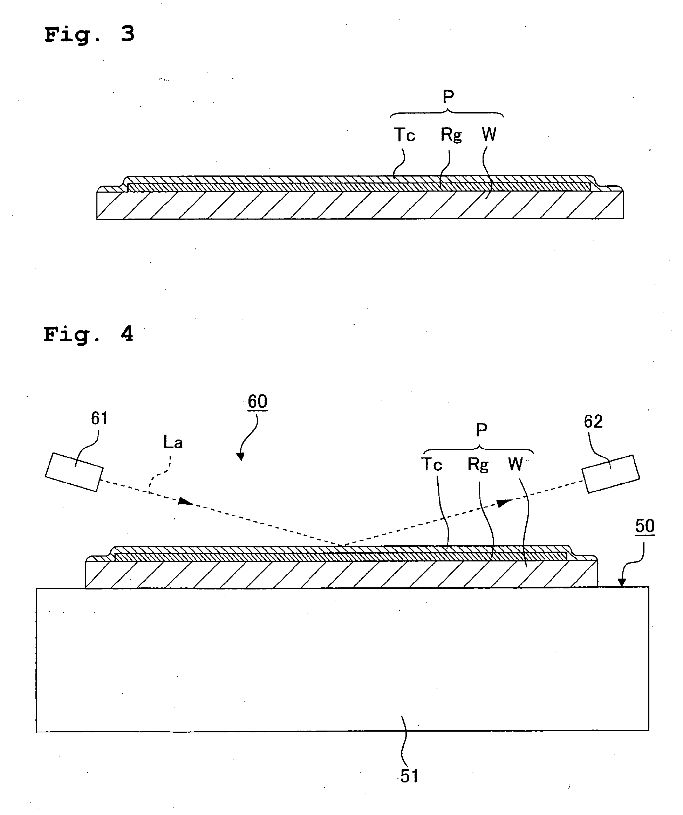

Fig. 3 shows an example of the substrate P on which thin films are formed by the coating device of the coater/developer apparatus C/D. With reference to Fig. 3, the substrate P has a base material W such as a semiconductor wafer, a first film Rg which is formed on the base material W, and a second film Tc which is formed on the first film Rg. The first film Rg is a film made of a photosensitive material (photoresist). The second film Tc is a film called "top coat film" and has, for example, the function to protect at least one of the first film Rg and the base material W from the liquid LQ and which is liquid-repellent (water-repellent) with respect to the liquid LQ. When the second film Tc, which is the liquid-repellent film, is provided, it is possible to enhance the recovery performance to recover the liquid LQ as well. The first film Rg is formed, for example, by coating the photosensitive material (photoresist) on the surface of the base material W by the spin coating system. Similarly, the second film Tc is also formed by coating, on the surface of the substrate P, a material for forming the top coat film. Since the liquid immersion area LR of the liquid LQ is formed on the second film Tc of the substrate P, the second film Tc of the substrate P forms a liquid contact surface which makes contact with the liquid LQ of the liquid immersion area LR. In this embodiment, the contact angle of the liquid LQ when the liquid LQ is placed on the second film Tc, is not less than 90°. In this embodiment, "TSP-3A" produced by TOKYO OHKA KOGYO CO., LTD. is used as the forming material (liquid-repellent material) for forming the second film Tc.

Fig. 4 shows the detector 60. The detector 60 has the light-emitting system 61 which radiates the detecting light La onto the substrate P, and the light-receiving system 62 which is capable of receiving the detecting light La via the substrate P. The detector 60 optically detects the state of formation of the second film Tc on the substrate P. As described above, the second film Tc is formed by coating, on the surface of the substrate P, the predetermined material for forming the top coat film. The detector 60 detects the coating state of the second film Tc or any defect of the second film Tc. In this specification, the term "defect of the thin film" is a concept which includes not only the defective or imperfect state (coating state) of the thin film formed on the substrate P but also a fact that the state of the edge of the substrate P is defective as described later on.

The detector 60 is provided on the transport path of the transport device H. The detector 60 detects the state of formation of the second film Tc before the liquid immersion area LR is formed on the substrate P. That is, the detector 60 detects the state of formation of the second film Tc not through the liquid LQ.

When the controller 7 detects the state of formation of the second film Tc on the substrate P by using the detector 60, the detecting light La is radiated onto the substrate P while relatively moving the detecting light La and the substrate P. In this embodiment, the temperature-adjusting holder 51 which holds the substrate P is provided movably in the XY directions. The controller 7 radiates the detecting light La from'the light-emitting system 61 onto the substrate P while moving the temperature-adjusting holder 51 which holds the substrate P in the XY directions. With this, the detecting light La is radiated substantially onto the entire region of the surface of the substrate P. The detecting light La may be radiated onto the surface of the substrate P while moving the detector 60 with respect to the substrate P held by the temperature-adjusting holder 51. It is also allowable to move both of the detector 60 and the temperature-adjusting holder 51 which holds the substrate P. In the drawing, the detecting light La, which is radiated from the light-emitting system 61, is depicted as a single light. However, the light-emitting system 61 is also capable of radiating a plurality of detecting lights La simultaneously onto the substrate P. In this case, the light-receiving system 62 is provided with light-receiving surfaces corresponding to the plurality of detecting lights La.

The detector 60 detects the state of formation of the second film Tc of the substrate P loaded into the temperature-adjusting device 50. In this embodiment, the detector 60 detects the state of formation of the second film Tc of the substrate P which is held by the temperature-adjusting holder 51 of the temperature-adjusting device 50 and to which the temperature-adjusting process is applied. That is, the process for detecting the state of formation of the second film Tc of the substrate P by the detector 60 and the process for adjusting the temperature of the substrate P by the temperature-adjusting device 50 are concurrently performed.

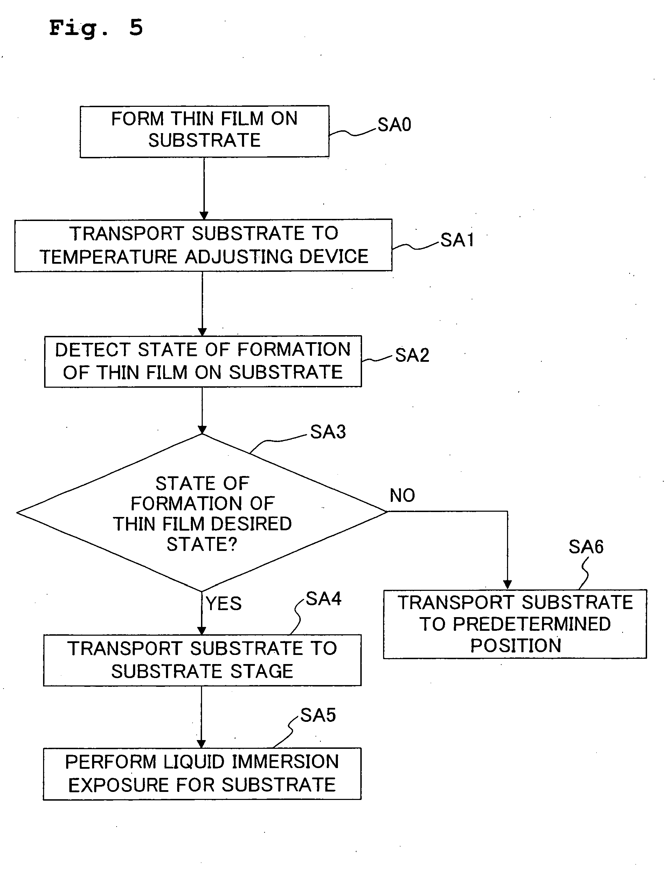

Next, an explanation will be made with reference to a flow chart shown in Fig. 5 about a method for exposing the substrate P by using the exposure apparatus EX constructed as described above.

At first, the first film Rg and the second film Tc are formed on the substrate P by using the coating device of the coater/developer apparatus C/D (SAO). Subsequently, the substrate P, on which the first film Rg and the second film Tc have been formed as described above, is loaded from the coating device into the exposure apparatus EX in order that the substrate P is exposed through the liquid. Predetermined processes are applied to the substrate P by various processing units or devices, other than the coater/developer apparatus C/D, before the substrate P is transported to the substrate stage 4 of the exposure-apparatus body S.

The controller 7 transports the substrate P to the temperature-adjusting device 50 by using the transport device H (Step SA1). That is, the transport device H loads or transports the substrate P into the temperature-adjusting device 50 before the substrate P is transported to the substrate stage 4. The substrate P is held by the temperature-adjusting holder 51 of the temperature-adjusting device 50. The temperature-adjusting device 50 adjusts the temperature of the substrate P before the substrate P is transported to the substrate stage 4. In particular, the temperature-adjusting device 50 adjusts the temperature of the substrate P depending on the temperature of the substrate holder 4H of the substrate stage 4 and/or the temperature of the liquid LQ forming the liquid immersion area LR. For example, the temperature-adjusting device 50 adjusts the temperature of the substrate P so that the temperature is coincident with the temperature of the substrate holder 4H (or of the liquid LQ).

The controller 7 uses the detector 60 to detect the state of formation of the second film Tc of the substrate P loaded into the temperature-adjusting device 50 and held by the temperature-adjusting holder 51 (Step SA2). The detector 60 radiates the detecting light La from the light-emitting system 61 onto the surface of the substrate P. The controller 7 makes the detecting light La to be radiated onto the substrate P while controlling the detector 60 to relatively move the detecting light La and the substrate P. Accordingly, it is possible to detect the state of formation of the second film Tc in the substantially entire region of the surface of the substrate P. The detecting light La, which is reflected by the surface of the substrate P, is received by the light-receiving system 62. The light-receiving result of the light-receiving system 62 is outputted to the controller 7.

The relationship between the state of formation of the second film Tc and the light-receiving state of the light-receiving system 62 is previously stored in the storage device 8. The controller 7 judges whether or not the state of formation of the second film Tc is the desired state, based on the storage information stored in the storage device 8 and the light-receiving result of the light-receiving system 62 (Step SA3).

For example, when the second film Tc is formed in the desired state, the detecting light La, which is radiated onto the substrate P (second film Tc), arrives at a predetermined position of the light-receiving surface of the light-receiving system 62 in a predetermined light amount. On the other hand, if at least a part of the second film Tc is not formed in the desired state, and at least the part of the second film Tc is in the defective state, then the following situation arises. That is, the light amount of the detecting light La arriving at the light-receiving system 62 is changed (lowered) as compared with the case of the desired state; the position of the detecting light La arriving at the light-receiving surface of the light-receiving system 62 is changed; and/or the detecting light La does not arrive at the light-receiving system 62. A state that "second film Tc is defective" or a state that "defect is present in the second film Tc" includes such a state that any area, in which the second film Tc is not formed (coated) at all or the second film Tc is formed only partially, is present on the substrate P, and/or any area, in which the second film Tc is not formed to have a desired thickness (film thickness), is present on the substrate P.

The light-receiving state, which is obtained by the light-receiving system 62 when the detecting light La is radiated onto the substrate P (second film Tc) in the desired state, can be previously determined, for example, by an experiment and/or simulation. Therefore, when an information about the light-receiving state in the light-receiving system 62 which is obtained when the detecting light La is radiated onto the substrate P (second film Tc) in the desired state, is previously stored in the storage device 8, the controller 7 can thereby judge whether or not the state of formation of the second film Tc is the desired state, especially the desired state preferred for the liquid immersion exposure, based on the light-receiving result of the light-receiving system 62 and the storage information stored in the storage device 8.

The controller 7 controls the operation of the transport device H based on the detection result of the light-receiving result of the light-receiving system 62 (detection result of the detector 60). Specifically, if the controller 7 judges in Step SA3 that the state of formation of the second film Tc is the desired state, based on the detection result of the light-receiving result of the light-receiving system 62 (detection result of the detector 60), then the controller 7 uses the transport device H to transport the substrate P to the substrate stage 4 of the exposure-apparatus body S after completing the process for adjusting the temperature of the substrate P with the temperature-adjusting device 50 (Step SA4). The substrate P, which has been loaded to the substrate stage 4, is held by the substrate stage 4 (substrate holder 4H). The controller 7 performs, for example, predetermined process such as an alignment process to the substrate P held by the substrate stage 4, and the controller 7 uses the liquid immersion mechanism 1 to form the liquid immersion area LR of the liquid LQ on the substrate P. The controller 7 starts the liquid immersion exposure for the substrate P (Step SA5).

The exposure apparatus EX of this embodiment is a scanning type exposure apparatus (so-called scanning stepper) in which the substrate P is exposed with the image of the pattern formed on the mask M while synchronously moving the mask M and the substrate P in the scanning direction. The controller 7 successively exposes a plurality of shot areas defined on the substrate P through the liquid LQ while moving the mask M and the substrate P with respect to the exposure light EL and while measuring the position information about the mask M (mask stage 3) and the substrate P (substrate stage 4) by using the laser interferometers 3L, 4L. After completing the exposure process for the substrate P, the controller 7 retracts or removes the liquid immersion area LR from the surface of the substrate P, and uses the transport device H to unload the substrate P from the substrate stage 4 and to transport the substrate P to the coater/developer apparatus C/D (developer device).

On the other hand, if the controller 7 judges in Step SA3 that the state of formation of the second film Tc is the defective state, based on the light-receiving result of the light-receiving system 62 (detection result of the detector 60), then the controller 7 uses the transport device H to transport the substrate P to a predetermined position which is different from the substrate stage 4 (Step SA6). For example, if the controller 7 judges that the state of formation of the second film Tc is the defective state, the controller 7 uses the transport device H to transport the substrate P from the temperature-adjusting device 50, for example, to the coater/developer apparatus C/D. Alternatively, the controller 7 uses the transport device H to withdraw the substrate P to a predetermined withdrawal position. The substrate P, which is judged to have a defective second film Tc, may be discarded, or may be reused after re-forming the film.

In the liquid immersion exposure, the contact state (contact angle) between the liquid LQ and the liquid contact surface of the substrate P is optimized in order that the liquid LQ is retained satisfactorily between the projection optical system PL and the substrate P to form the liquid immersion area LR in the desired state. That is, in the liquid immersion exposure, the thin film (second film Tc) on the substrate P is formed depending on the liquid LQ. If the state of formation of the second film Tc is the defective state, there is a possibility that the following inconvenience may arise. That is, for example, the liquid LQ cannot be retained satisfactorily between the projection optical system PL and the substrate P, and the liquid LQ outflows; the liquid LQ cannot be recovered satisfactorily via the recovery port 22; the liquid LQ remains on the substrate P; the liquid immersion area LR is not formed satisfactorily, and any gas portion is formed in the optical path space K for the exposure light EL; and the like. Therefore, if the substrate P, in which the state of formation of the second film Tc is the defective state, is loaded onto the substrate stage 4, and the liquid immersion exposure is performed, then any inconvenience arises, for example, such that the liquid LQ outflows to cause any damage on a peripheral device disposed in the vicinity of the substrate stage 4. In particular, if the outflowed liquid adheres to or inflows into the peripheral device, a situation may arise such that the operation of the exposure apparatus is inevitably stopped. For example, such a situation may arise when the photoresist film and/or the top coat film is not formed on the substrate due to any malfunction of the coater/developer apparatus C/D. If the substrate, on which the film is not formed as described above, is transported to the substrate stage, there is a possibility that the liquid, which is supplied onto the substrate, cannot stay or remain on the substrate, and the liquid may outflow to the outside of the substrate. That is, the situation, in which the film is not formed on the substrate as planned, consequently causes any extremely series damage in the liquid immersion exposure. That is, in a case of the conventional exposure in which the exposure is performed not through the liquid (dry exposure), it is enough in such a situation that the exposure is performed again after the substrate, on which the film is not formed, is exchanged to another substrate on which the film is properly formed. In this case, any failure of the exposure apparatus itself is very unlikely, although the throughput is affected. On the contrary, in the case of the liquid immersion exposure, the inventors have found out through the experiment that it is necessary to avoid the failure of the exposure apparatus itself beforehand.

In other situations, there is a possibility, for example, that the exposure light EL, passing through the liquid immersion area LR in the defective state, is radiated onto the substrate P, and/or the water mark is formed on the substrate P resulting from the liquid LQ remaining on the substrate P, which in turn makes the produced device to be defective. If such a defective device is produced, the throughput in device production is consequently lowered. This problem is also inherent in the liquid immersion exposure. In this embodiment, the state of formation of the second film Tc is detected before the substrate P is loaded into the substrate stage 4. Accordingly, if the state of formation of the second film Tc is the defective state, then it is possible to adopt an appropriate measure, for example, such that the substrate P is transported to the coater/developer apparatus C/D without transporting the substrate P to the substrate stage 4. Such a substrate P is not transported to the substrate stage 4, and hence the liquid immersion area LR is not formed on the substrate P as well. Therefore, it is possible to avoid the occurrence of the inconvenience as described above, and it is possible to suppress the decrease in the throughput in device production.

As explained above, the detector 60 is provided to detect the state of formation of the thin film (second film Tc) on the substrate P. Therefore, the detection result of the detector 60 can be used to suppress the decrease in the throughput in device production, and it is possible to adopt the appropriate measure in order to avoid the failure or disorder of the exposure apparatus beforehand.

In this embodiment, the detector 60 detects the state of formation of the second film Tc of the substrate P loaded into the temperature-adjusting device 50. The process for detecting the state of formation of the second film Tc of the substrate P by the detector 60 and the process for adjusting the temperature of the substrate P by the temperature-adjusting device 50 are concurrently performed. Therefore, it is possible to improve the process efficiency. It is not necessarily indispensable that the detecting process and the temperature-adjusting process are performed simultaneously. The temperature-adjusting process may be performed after the detecting process, or the detecting process may be performed after the temperature-adjusting process.

In this embodiment, the detector 60 is provided in the vicinity of the temperature-adjusting device 50. However, the detector 60 may be provided at any arbitrary position on the transport path of the transport device H. For example, when a prealignment device, which roughly positions the substrate P, with respect to the substrate stage 4, before the substrate P is loaded on the substrate stage 4, is provided on the transport path of the transport device H, then the detector 60 can be provided in the vicinity of the prealignment device. The detector 60 can detect the state of formation of the second film Tc of the substrate P loaded into the prealignment device. The controller 7 can concurrently perform the process for detecting the state of formation of the second film Tc of the substrate P by the detector 60 and the process for positioning the substrate P by the prealignment device. Of course, the detector 60 may be provided in the vicinity of any other processing device which is different from the temperature-adjusting device 50 and/or the prealignment device, and the state of formation the second film Tc of the substrate P loaded into the processing device may be detected. Alternatively, the detector 60 may detect the state of formation of the second film Tc of the substrate P that the substrate P is held by the transport device H. The detector 60 may be used also as any other processing device (for example, the temperature-adjusting device 50 or the prealignment device).

In the first embodiment, the focus/leveling-detecting system 30 is arranged to obtain the surface information of the substrate P through the liquid LQ of the liquid immersion area LR. However, the focus/leveling-detecting system 30 may be omitted, and the surface information of the substrate P may be obtained not through the liquid LQ in the measuring station disposed separately and away from the projection optical system PL.

### Second Embodiment

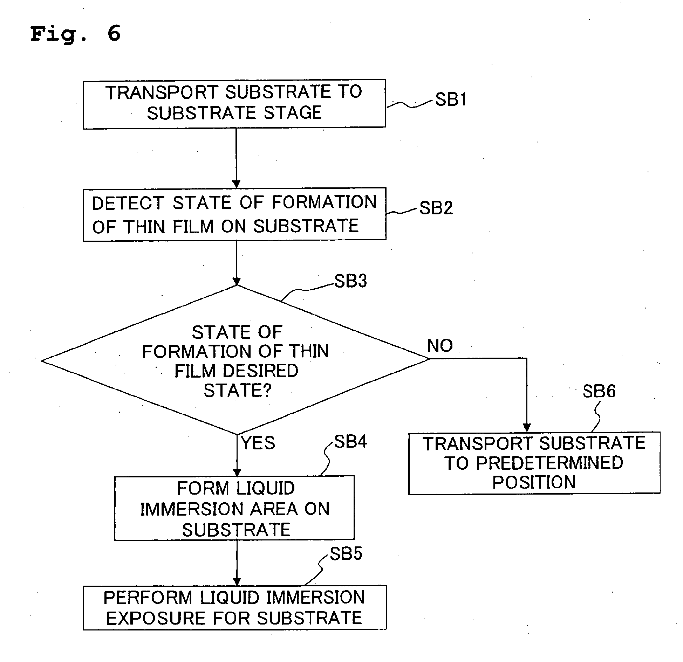

Next, a second embodiment will be explained with reference to a flow chart shown in Fig. 6. The feature of this embodiment is detecting the state of formation of the thin film on the substrate P in a state that the substrate P is held by the substrate holder 4H. In the following description, the constitutive parts or components, which are the same as or equivalent to those of the embodiment described above, are designated by the same reference numerals, any explanation of which will be simplified or omitted.

The substrate P, on which the first film Rg and the second film Tc are formed by the coating device of the coater/developer apparatus C/D, is loaded into the exposure apparatus EX in order to perform the exposure through the liquid. The substrate P is subjected to the predetermined processes by various processing units or devices including the temperature-adjusting device 50, before the substrate P is transported to the substrate stage 4 of the exposure-apparatus body S. After the processes by the various processing devices including the temperature-adjusting device 50 are completed, the controller 7 uses the transport device H to transport the substrate P to the substrate stage 4 (substrate holder 4H) (Step SB1).

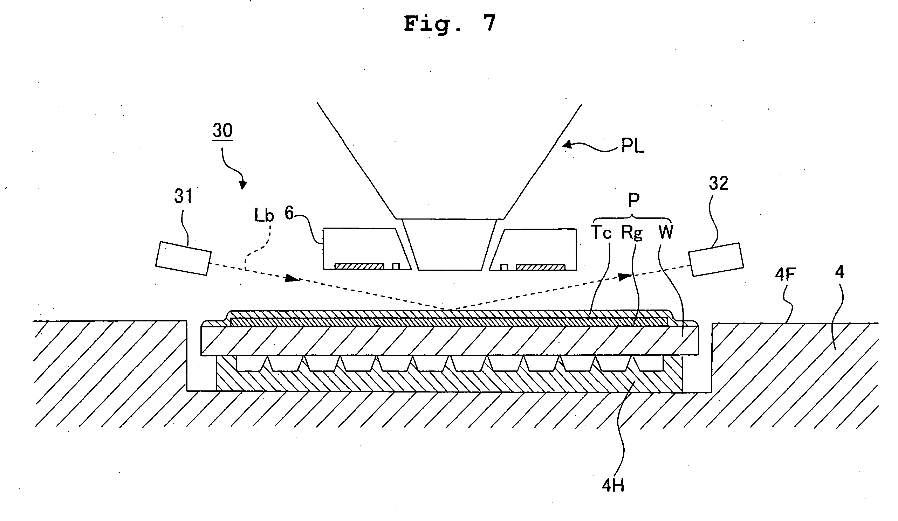

The controller 7 uses the focus/leveling-detecting system 30 to detect the state of formation of the second film Tc on the substrate P in the state that the substrate P is loaded into the substrate stage 4 and held by the substrate holder 4H (Step SB2). As shown in Fig. 7, the controller 7 uses the focus/leveling-detecting system 30 to detect the state of formation of the second film Tc before the liquid immersion area LR is formed on the substrate P. The focus/leveling-detecting system 30 is constructed in an approximately same manner as the detector 60, and is capable of optically detecting the state of formation of the second film Tc. That is, when the second film Tc is formed in the desired state, the detecting light Lb, which is radiated onto the substrate P (second film Tc) by the light-emitting system 31, arrives at a predetermined position of the light-receiving surface of the light-receiving system 32 in a predetermined light amount. On the other hand, if at least a part of the second film Tc is in the defective state, the following situation arises. That is, for example, the light amount of the detecting light Lb arriving at the light-receiving system 32 is changed (lowered) as compared with the case in which the state is the desired state, and/or the position of the detecting light Lb arriving at the light-receiving surface of the light-receiving system 32 is changed. The controller 7 makes the detecting light Lb be radiated onto the substrate P while relatively moving the detecting light Lb radiated from the light-emitting system 31 and the substrate P on the substrate stage 4 to detect the state of formation of the second film Tc on the substrate P.

The relationship between the state of formation of the second film Tc and the light-receiving state of the light-receiving system 32 is stored beforehand in the storage device 8 in the same manner as in the first embodiment described above. The controller 7 judges or distinguishes whether or not the state of formation of the second film Tc is the desired state, based on the storage information stored in the storage device 8 and the light-receiving result of the light-receiving system 32 (Step SB3).

If the controller 7 judges in Step SB3 that the state of formation of the second film Tc is the desired state based on the light-receiving result of the light-receiving system 32 (detection result of the focus/leveling-detecting system 30), then the controller 7 uses the liquid immersion mechanism 1 to perform the predetermined process including, for example, the alignment process for the substrate P held by the substrate holder 4H, and to form the liquid immersion area LR of the liquid LQ on the substrate P held by the substrate holder 4H (Step SB4). The controller 7 performs the liquid immersion exposure for the substrate P (Step SB5).

When the liquid immersion exposure is performed for the substrate P, the controller 7 exposes the substrate P while adjusting the position of the substrate P based on the surface position information about the substrate P detected by the focus/leveling-detecting system 30. In this embodiment, the focus/leveling-detecting system 30 radiates the detecting light Lb on the surface of the substrate P onto the position which is at the outside of the liquid immersion area LR. The surface position information about the substrate P is detected not through the liquid LQ. The focus/leveling-detecting system 30 may detect the surface position information about the substrate P through the liquid LQ.

After the exposure process for the substrate P is completed, the controller 7 uses the transport device H to unload the substrate P from the substrate stage 4 and to transport the substrate P to the coater/developer apparatus C/D (developer device).

On the other hand, if the controller 7 judges in Step SB3 that the state of formation of the second film Tc is the defective state, based on the light-receiving result of the light-receiving system 32 (detection result of the focus/leveling-detecting system 30), the controller 7 uses the transport device H to unload the substrate P from the substrate stage 4 and to transport the substrate P to a predetermined position (Step SB6). If the controller 7 judges that the state of formation of the second film Tc is the defective state, the controller 7 uses the transport device H to transport the substrate P from the substrate stage 4, for example, to the coater/developer apparatus C/D. Alternatively, the controller 7 uses the transport device H to withdraw or remove the substrate P to a predetermined withdrawal position.

In this embodiment, the state of formation of the second film Tc is detected not through the liquid LQ before the liquid immersion area LR is formed on the substrate P. However, the state of formation of the second film Tc may be detected, after the liquid immersion area LR is formed on the substrate P, through the liquid LQ by using the focus/leveling-detecting system 30. In view avoiding beforehand any harmful influence to be exerted on the exposure apparatus by the outflow of the liquid LQ from the substrate, it is desirable that the state of formation of the second film Tc is detected before the substrate is loaded into the substrate stage 4.

In the second embodiment, it is also allowable that the detector 60 is not provided. Alternatively, the state of formation the thin film on the substrate P loaded into the substrate stage 4 may be checked again after the state of formation of the thin film on the substrate P is checked by the detector 60.

In each of the embodiments described above, the state of formation of the thin film is detected based on the reflected light beam of the detecting light radiated onto the surface of the substrate P. However, as disclosed, for example, in Japanese Patent Application Laid-open No. 2002-141274, it is also possible to use a film thickness measuring apparatus which is provided with a film thickness measuring device of the light interference system, and which is capable of radiating the light beam onto a surface of the substrate P on which the thin film is formed to determine the spectrum of the reflected light beam, and to measure the film thickness (film thickness distribution) based on the spectrum. The controller 7 can judge whether or not the state of formation of the thin film on the substrate P is the desired state, based on the measurement result of the film thickness measuring apparatus.

Alternatively, a liquid (liquid droplets) may be scattered or sprinkled on the surface of the substrate P in order to detect the state of formation of the thin film on the substrate P, and then the state of the liquid scattered on the surface of the substrate P may be observed with an image pickup device such as CCD. The state of the liquid scattered on the surface of the substrate P (for example, the state of formation of the film of the liquid) differs between a case in which the state of formation of the thin film formed on the substrate P is the desired state and a case in which the state of formation of the thin film formed on the substrate P is the defective state. Therefore, the controller 7 can perform the image processing for the image pickup result of the image pickup device, and the controller 7 can detect the state of formation of the thin film on the substrate P based on the processing result.

### Third Embodiment

Next, a third embodiment will be explained. As described above, the surface information (surface position information) about the substrate P can be obtained not through the liquid LQ in a measuring station disposed separately and away from the projection optical system PL, and the focus/leveling-detecting system can be provided for the measuring station in order to obtain the surface information about the substrate P. The focus/leveling-detecting system, which is provided for the measuring station, can be used to detect the state of formation of the thin film on the substrate P. In this embodiment, an explanation will be made as exemplified by a case in which the state of formation of the thin film on the substrate P is detected by using the focus/leveling-detecting system provided for the measuring station. In the following description, the constitutive parts or components, which are the same as or equivalent to those of the embodiment described above, are designated by the same reference numerals, any explanation of which will be simplified or omitted.

In the exposure apparatus EX of this embodiment, the measuring station is provided with a mark-detecting system 40 which detects an alignment mark on the substrate P. The mark-detecting system 40 of this embodiment is capable of detecting the state of an edge of the substrate P. In this embodiment, the mark-detecting system 40 detects the alignment mark on the substrate P held by the substrate stage 4 and the state of the edge of the substrate P before the liquid immersion area LR of the liquid LQ is formed on at least a part of the surface of the substrate P.

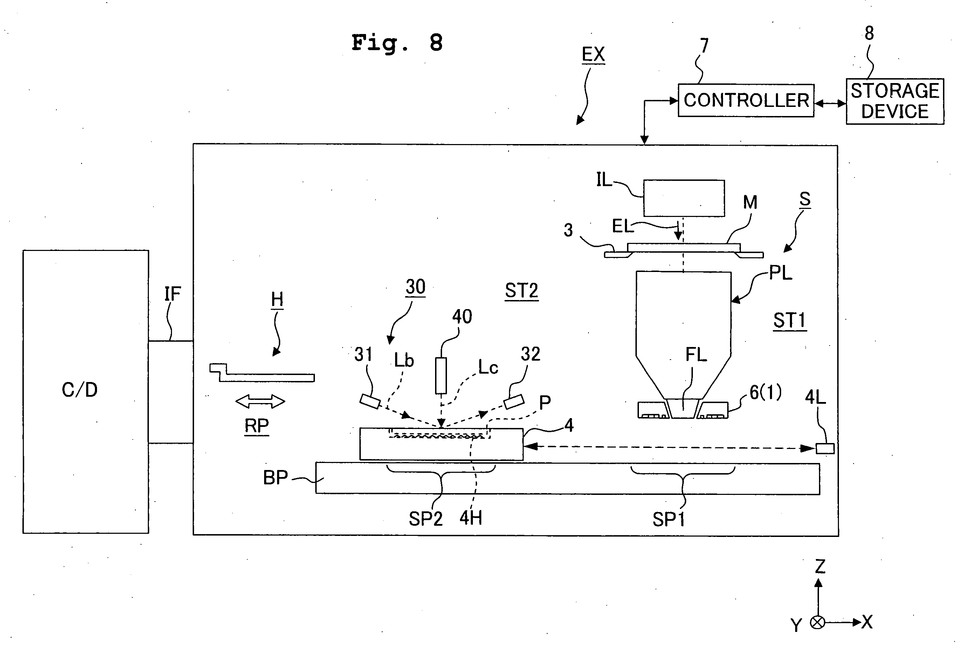

Fig. 8 is a schematic arrangement view of an exposure apparatus EX according to the third embodiment. With reference to Fig. 8, the exposure apparatus EX is provided with an exposure station ST1 in which the substrate P is exposed, and a measuring station ST2 which is provided at a position separated and away from the projection optical system PL and in which a predetermined measurement and an exchange of the substrate P are performed. The projection optical system PL, the nozzle member 6, and other components are provided in the exposure station ST1, and the focus/leveling-detecting system 30, the mark-detecting system 40, and other components are provided in the measuring station ST2. The substrate stage 4 is movable while holding the substrate P in a predetermined area on the base member BP, the predetermined area including a first area SP1 in which the exposure light EL can be radiated from the projection optical system PL of the exposure station ST1 and a second area SP2 in which the detecting lights Lb, Lc can be radiated from detecting systems 30, 40 of the measuring station ST2. The first area SP1 includes a position which is under or below the projection optical system PL and at which the exposure light EL can be radiated. The second area SP2 includes a position which is under or below the detecting systems 30, 40 and at which the detecting lights Lb, Lc can be radiated. The first area SP1 and the second area SP2 are different areas. A part of the first area SP1 and a part of the second area SP2 may be overlapped with each other. The substrate stage 4 can hold the substrate P at the position, in the exposure station ST1, at which the exposure light EL can be radiated. The substrate stage 4 can hold the substrate P at the position, in the measuring station ST2, at which the detecting lights Lb, Lc can be radiated. Fig. 8 shows a state that the substrate stage 4 is arranged in the measuring station ST2. Further, an actuator (for example, a linear motor) driving the substrate stage 4 and/or the laser interferometer may differ between the exposure station ST1 and the measuring station ST2.

As shown in Fig. 8, a transport device H is provided in the vicinity of the measuring station ST2 in order to exchange the substrate P. The controller 7 is capable of executing the operation (substrate exchange operation, by using the transport device H, to unload a substrate P having been subjected to the exposure process from the substrate stage 4 moved to a substrate exchange position (loading position) RP of the measuring station ST2, and to load another substrate P to be subjected to the exposure process onto the substrate stage 4. In this embodiment, the load and the unload of the substrate P are performed at a same position (substrate exchange position) RP. However, the load and the unload may be performed at different positions.

The focus/leveling-detecting system 30 has a light-emitting system 31 which radiates the detecting light Lb onto the substrate P held by the substrate stage 4, and a light-receiving system 32 which is capable of receiving the detecting light Lb via the substrate P, in the same manner as in the embodiment described above. The light-emitting system 31 emits the detecting light Lb, in an oblique direction, onto a surface of the substrate P held by the substrate stage 4 arranged in the measuring station ST2. The light-receiving system 32 is capable of receiving the detecting light Lb which is radiated onto a surface of the substrate P by the light-emitting system 31 and which is reflected on the surface thereof. The focus/leveling-detecting system 30 detects the surface position information (surface position information in relation to the Z axis, θX, and θY directions) about the surface of the substrate P held by the substrate stage 4.

The mark-detecting system 40 is an alignment system including an optical device which obtains the alignment information (position information in the X, Y, and θZ directions of a plurality of shot areas on the substrate P) of the substrate P held by the substrate stage 4, and capable of detecting the alignment marks formed on the substrate P. Further, the mark-detecting system 40 is capable of detecting the state of the edge of the substrate P. The mark-detecting system 40 includes a radiating device which radiates, onto an objective, the detecting light Lc different from the exposure light EL, and an image pickup device which obtains an optical image (image) of the objective illuminated with the detecting light Lc radiated from the radiating device. The mark-detecting system obtains an image of the mark on the substrate P by radiating the detecting light Lc onto the substrate P. The mark-detecting system 40 can illuminate the edge of the substrate P with the detecting light Lc to obtain an image of the edge of the substrate P illuminated with the detecting light Lc. The detection result of the mark-detecting system 40 is outputted to the controller 7.

The mark-detecting system 40 of this embodiment is the alignment system of the FIA (Field Image Alignment) system as disclosed, for example, in Japanese Patent Application Laid-open No. 4-65603 (corresponding to United States Patent No. 5,493,403), which radiates, onto objective mark (for example, the alignment mark formed on the substrate P), a detecting light Lc having a wavelength different from that of the exposure light EL and not photosensitizing the photosensitive material on the substrate P, and which photographs or images an image of the mark as the detection objective focused on a light-receiving surface by the reflected light beam from the objective mark and an image of an index (reference mark on a reference plate provided in the mark-detecting system 40) by using the image pickup device (CCD or the like), thereby subjecting the image pickup signals of the images to the image processing to measure the position of the mark. The index of a mark-detecting system 40 defines the detection reference position of the mark-detecting system 40 in a coordinate system defined by the laser interferometer 4L. The mark-detecting system 40 can detect the positional relationship (positional deviation) between the detection objective mark and the detection reference position in the coordinate system defined by the mark-detecting system 40, by detecting the positional relationship (positional deviation) between the index and the image of the detection objective mark.

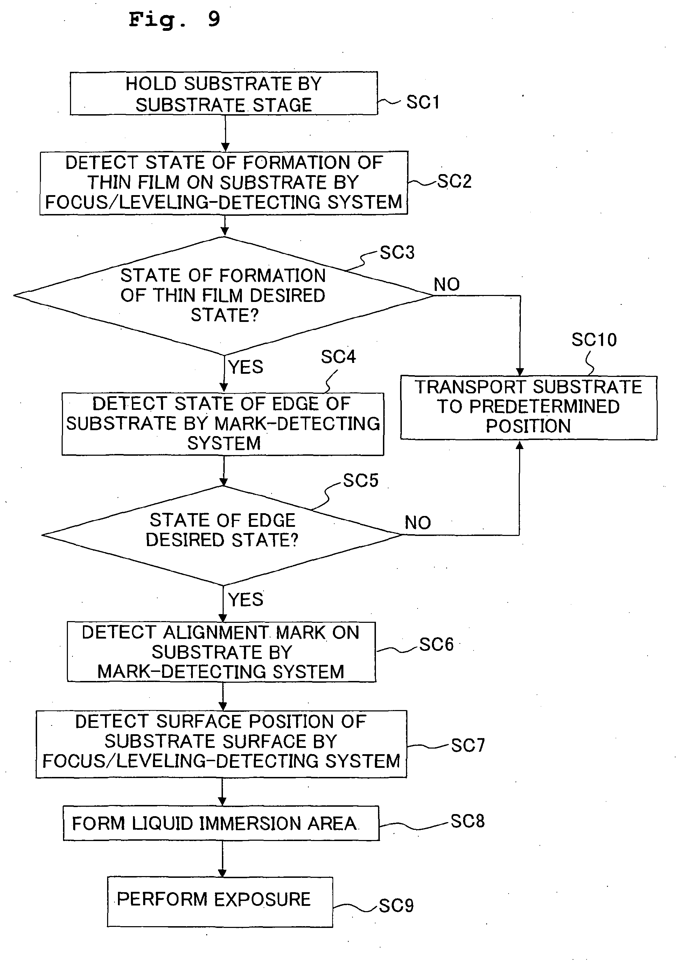

Next, an explanation will be made with reference to a flow chart shown in Fig. 9 about an example of the operation of the exposure apparatus EX according to this embodiment. In this embodiment, the controller 7 loads the substrate P, to be subjected to the exposure process next, on the substrate stage 4 in the measuring station ST2. After that, the controller 7 uses the focus/leveling-detecting system 30 in the same manner as in the embodiment described above to detect the state of formation of the thin film on the substrate P held by the substrate stage 4 located in the measuring station ST2. Further, the controller 7 uses the mark-detecting system 40 to detect the state of the edge of the substrate P held by the substrate stage 4 located in the measuring station ST2. Further, the controller 7 uses the focus/leveling-detecting system 30 and the mark-detecting system 40 to obtain the position information about the substrate P held by the substrate stage 4 located in the measuring station ST2 not through the liquid LQ. Here, the term "position information about the substrate P" includes a surface position information (position information in the Z, θX, and θY directions) of the substrate P with respect to a predetermined reference surface such as an image plane of the projection optical system PL, and an alignment information (position information in the X, Y, and θZ directions of the plurality of shot areas on the substrate P) of the substrate P with respect to the predetermined reference position.

In the following description, a state that the optical path space K is not filled with the liquid LQ, is appropriately referred to as "dry state", and a state that the optical path space K is filled with the liquid LQ, is appropriately referred to as "wet state". The image plane, which is formed via the projection optical system PL and the liquid LQ, is appropriately referred to as "image plane formed in the wet state".

The controller 7 starts the exchange of the substrate P and the predetermined measurement process in the measuring station ST2. For example, the controller 7 arranges the substrate stage 4 at the substrate exchange position RP in the measuring station ST2, and the controller 7 uses the transport device H to load the substrate P to be subjected to the exposure process on the substrate stage 4. The substrate stage 4 holds the substrate P in the measuring station ST2 (Step SC1).

After the substrate P is held by the substrate stage 4, the controller 7 uses the focus/leveling-detecting system 30 to detect in the measuring station ST2 the state of formation of the second film Tc on the substrate P in the state that the substrate P is held by the substrate stage 4 (Step SC2). As shown in Fig. 8, the measuring station ST2 is arranged at a position at which the upper surface of the substrate stage 4 is not opposite to or facing the projection optical system PL (nozzle member 6). The controller 7 detects the state of formation of the second film Tc by using the focus/leveling-detecting system 30 before the liquid immersion area LR is formed on at least a part of the surface of the substrate P. As explained in the second embodiment described above, when the second film Tc is formed in the desired state, the detecting light Lb, which is radiated onto the substrate P (second film Tc) by the light-emitting system 31 of the focus/leveling-detecting system 30, arrives at the predetermined position of the light-receiving surface of the light-receiving system 32 in the predetermined light amount. On the other hand, if at least a part of the second film Tc is in the defective state, the following situation arises. That is, for example, the light amount of the detecting light Lb arriving at the light-receiving system 32 is changed (lowered) as compared with a case of the desired state, and/or the position of the detecting light Lb arriving at the light-receiving surface of the light-receiving system 32 is changed. The controller 7 radiates the detecting light Lb onto the substrate P while relatively moving the detecting light Lb emitted from the light-emitting system 31 and the substrate P disposed on the substrate stage 4 in order to detect the state of formation of the second film Tc on the substrate P.

The relationship between the state of formation of the second film Tc and the light-receiving state of the light-receiving system 32 is previously stored in the storage device 8 in the same manner as in the embodiment described above. The controller 7 judges or determines whether or not the state of formation of the second film Tc is the desired state, based on the storage information stored in the storage device 8 and the light-receiving result of the light-receiving system 32 (Step SC3).

If the controller 7 judges in Step SC3 that the state of formation of the second film Tc is the defective state, based on the detection result of the focus/leveling-detecting system 30, then the controller 7 uses the transport device H to unload the substrate P from the substrate stage 4 and to transport the substrate P to a predetermined position (Step SC10). If the controller 7 judges that the state of formation of the second film Tc is the defective state, the controller 7 uses the transport device H to transport the substrate P from the substrate stage 4, for example, to the coater/developer apparatus C/D. Alternatively, the controller 7 uses the transport device H to withdraw the substrate P to a predetermined withdrawal position.

If the controller 7 judges in Step SC3 that the state of formation of the second film Tc is the desired state, based on the light-receiving result of the light-receiving system 32 (detection result of the focus/leveling-detecting system 30), then the controller 7 uses the mark-detecting system 40 to detect the state of the edge of the substrate P in the state of being held by the substrate stage 4 (Step SC4). The mark-detecting system 40 detects the state of the edge of the substrate P held by the substrate stage 4 in the second area SP2 of the measuring station ST2 after the substrate P is held by the substrate stage 4.

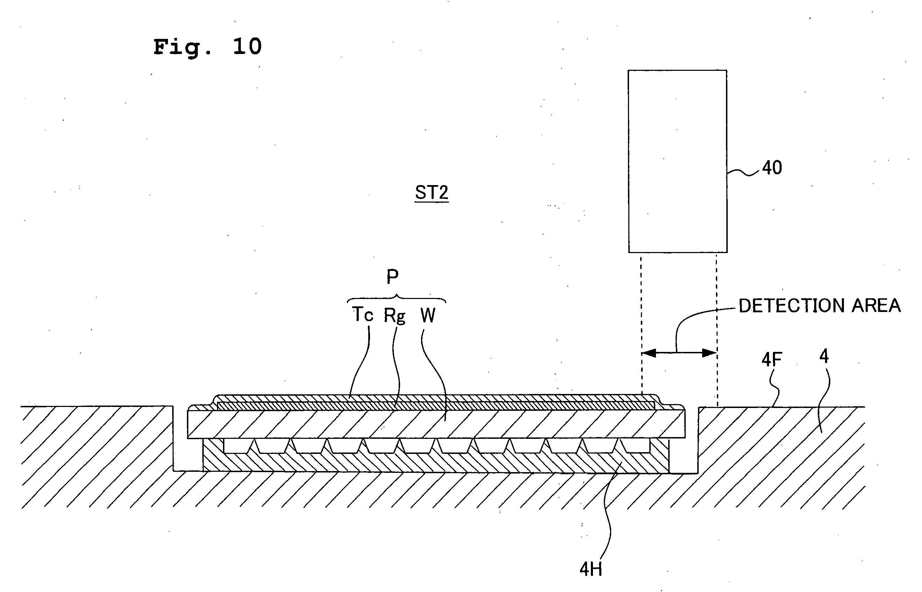

Fig. 10 schematically shows a situation in which the mark-detecting system 40 detects the state of the edge of the substrate P. The controller 7 moves the substrate stage 4 in the XY directions in the measuring station ST2 so that the edge of the substrate P held by the substrate stage 4 is arranged in the detection area of the mark-detecting system 40. As described above, the mark-detecting system 40 includes the image pickup device, and obtains the optical image (image) of the edge of the substrate P arranged in the detection area of the mark-detecting system 40. The controller 7 moves the substrate stage 4 to perform the detection by the mark-detecting system 40 while moving the edge of the substrate P with respect to a detection area of the mark-detecting system 40. In this embodiment, the entire region of the edge of the substrate P is detected by the mark-detecting system 40. The detection result (image pickup result) of the mark-detecting system 40 is outputted to the controller 7. The controller 7 judges whether or not the state of the edge of the substrate P is the desired state, based on the detection result of the mark-detecting system 40 (Step SC5).

The state of the edge of the substrate P includes a state of formation of the thin film at the edge of the substrate P. In this embodiment, the state of the edge of the substrate P includes a state of formation of at least one of the first film Rg and the second film Tc at the edge of the substrate P. As described above, the first film Rg is formed, for example, by coating the photosensitive material (photoresist) on the base material W by the spin coating system. The second film Tc is also formed by coating, on the substrate P, the material for forming the top coat film. In this embodiment, the mark-detecting system 40 detects the coating state (for example, presence or absence of the film, exfoliation of the film, and thickness of the film) of at least one of the first film Rg and the second film Tc at the edge of the substrate P.

The state of the edge of the substrate P also includes the state of the presence or absence (adhesion state) of any foreign matter at the edge of the substrate P. That is, the mark-detecting system 40 also detects whether or not any foreign matter is present at the edge of the substrate P.

In this embodiment, the image information about an ideal state of the edge of the substrate P is previously stored in the storage device 8. The controller 7 performs, for example, the image processing for the result of the detection (image pickup) of the edge of the substrate P by using the mark-detecting system 40 to compare the result of the image processing and the image information about the ideal state of the edge of the substrate P stored in the storage device 8. The controller 7 distinguishes whether or not the state of the edge of the substrate P detected (photographed) by the mark-detecting system 40 is the desired state based on the result of the comparison.

If the controller 7 judges in Step SC5 that the state of the edge of the substrate P is the defective state based on the detection result of the mark-detecting system 40, the controller 7 uses the transport device H to unload the substrate P from the substrate stage 4 and to transport the substrate P to a predetermined position without starting the exposure for the substrate P (Step SC10). For example, if the controller 7 judges that the state of the edge of the substrate P is the defective state, then the controller 7 uses the transport device H to transport the substrate P from the substrate stage 4, for example, to the coater/developer apparatus C/D. Alternatively, the controller 7 uses the transport device H to withdraw the substrate P to a predetermined withdrawal position. The phrase "state of the edge of the substrate P is the defective state" herein includes a state that the edge of the substrate P is not satisfactorily coated with at least one of the first film Rg and the second film Tc and a state that any foreign matter is present at the edge of the substrate P.

If the controller 7 judges in Step SC5 that the state of the edge of the substrate P is the desired state based on the detection result of the mark-detecting system 40, the controller 7 starts the operation for obtaining the position information about the substrate P held by the substrate stage 4.

In the measuring station ST2, the controller 7 uses the mark-detecting system 40 to detect the plurality of alignment marks corresponding to the plurality of shot areas on the substrate P not through the liquid, while using the laser interferometer 4L to measure the position information in the X axis direction and the Y axis direction of the substrate stage 4 which holds the substrate P (Step SC6). Accordingly, the controller 7 can determine the position information in relation to the X axis direction and the Y axis direction of the respective alignment marks in the coordinate system defined by the laser interferometer 4L. The controller 7 can determine, based on the position information, the coordinate position information (arrangement information) about the plurality of shot areas on the substrate. In this embodiment, the positional relationship between the detection area of the mark-detecting system 40 and the projection position of the pattern image formed via the projection optical system PL and the liquid LQ is previously measured and is stored in the storage device 8. Therefore, when each of the shot areas is exposed, each of the shot areas on the substrate P and the pattern image can be successively positionally adjusted in the desired state, based on the coordinate position information about each of the shot areas.

In the measuring station ST2, the controller 7 uses the focus/leveling-detecting system 30 to detect the surface position information about the surface of the substrate P held by the substrate stage 4 not through the liquid LQ (Step SC7).

In this embodiment, the controller 7 detects the surface positions at a plurality of detection points on the surface of the substrate P by using the focus/leveling-detecting system 30, while controlling the movement of the substrate stage 4 and moving the substrate stage 4 which holds the substrate P in the XY plane. For example, the controller 7 moves the substrate stage 4 while monitoring the output of the laser interferometer 4L to detect the surface position information by using the focus/leveling-detecting system 30 at a plurality of points in the plane (XY plane) of the surface of the substrate P. Accordingly, the controller 7 can determine the surface position information at the plurality of detection points on the surface of the substrate P in the coordinate system. The detection result of the focus/leveling-detecting system 30 is stored in the storage device 8 while corresponding the detection result to the position of the substrate P in the XY plane. The positional relationship between the surface position information detected by using the focus/leveling-detecting system 30 and the image plane formed via the projection optical system PL and the liquid LQ is previously determined. Therefore, when each of the shot areas is exposed, the surface of the substrate P and the image plane formed via the projection optical system PL and the liquid LQ can be positionally adjusted in the desired state, based on the surface position information detected and determined in Step SC7 by using the focus/leveling-detecting system 30.

After the controller 7 completed the respective processes including, for example, the detection of the state of formation of the thin film on the substrate P by using the focus/leveling-detecting system 30 in the second area SP2 of the measuring station ST2, the detection of the state of the edge of the substrate P by using the mark-detecting system 40, and the acquisition of the position information about the substrate P including the surface position information and the alignment information by using the mark-detecting system 40 and the focus/leveling-detecting system 30, then the controller 7 moves the substrate stage 4 to the first area SP1 of the exposure station ST1 onto which the exposure light EL can be radiated.

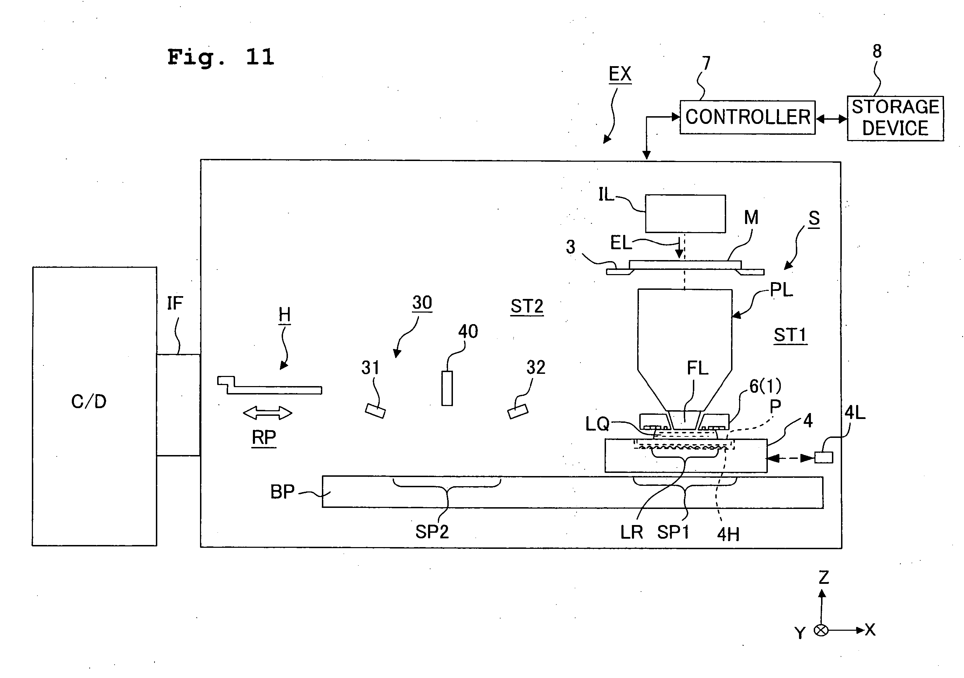

The controller 7 moves the substrate stage 4 holding the substrate P from the measuring station ST2 to the exposure station ST1, and then the controller 7 uses the liquid immersion mechanism 1 to form the liquid immersion area LR on the substrate stage 4 (substrate P) arranged in the first area SP1 of the exposure station ST1 (Step SC8). Then, the controller 7 controls the substrate stage 4 based on the surface position information about the surface of the substrate P determined in Step SC7 to adjust the position of the surface (exposure surface) of the substrate P, while the controller 7 controls the position of the substrate P in the X axis direction, the Y axis direction, and the θZ direction based on the coordinate position information (arrangement information) of the respective shot areas on the substrate P determined in Step SC6, thereby successively exposing the plurality of shot areas on the substrate P in the exposure station ST1 (Step SC9). The substrate stage 4 is capable of holding the substrate P, in the first area SP1 of the exposure station ST1, at a position at which the exposure light EL can be radiated. The controller 7 uses the liquid immersion mechanism 1 to form the liquid immersion area LR on the substrate P which is held by the substrate stage 4 arranged in the first area SP1 of the exposure station ST1. And the controller 7 makes the exposure light EL be radiated via the projection optical system PL and the liquid LQ onto the substrate P held by the substrate stage 4 in the first area SP1 to expose the substrate P. Fig. 11 shows the substrate stage 4 in a state that the substrate stage 4 is arranged in the exposure station ST1.

After completing the liquid immersion exposure process for the substrate P on the substrate stage 4, the controller 7 moves the substrate stage 4 in the exposure station ST1 to the measuring station ST2. The controller 7 uses the transport device H to unload the exposed substrate P which is held by the substrate stage 4 having been moved to the measuring station ST2.

As explained above, also in this embodiment, the state of formation of the thin film (second film Tc) on the substrate P is detected before the liquid immersion area LR of the liquid LQ is formed on at least a part of the surface of the substrate P. Therefore, if the state of formation of the thin film is defective, it is possible to adopt the appropriate measure, for example, such that the substrate P is transported, for example, to the coater/developer apparatus C/D, rather than arranging the substrate P in the first area SP1 of the exposure station ST1. Because the substrate P is not arranged in the exposure station ST1, the liquid immersion area LR is not formed on the substrate P as well. Therefore, it is possible to suppress the occurrence of the inconvenience including, for example, the outflow of the liquid LQ, and it is possible to suppress the decrease in the throughput in producing the device, in the same manner as in the embodiment described above.

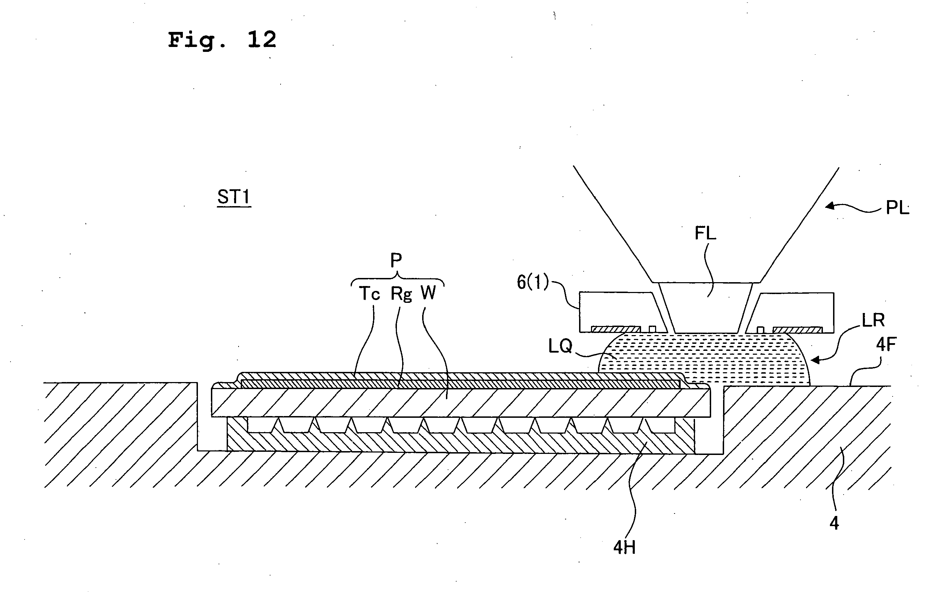

In this embodiment, the state of the edge of the substrate P is detected before the liquid immersion area LR of the liquid LQ is formed on at least a part of the surface of the substrate P. For example, if a part of at least one of the first film Rg and the second film Tc is exfoliated or removed from the base material W at the edge of the substrate P, the following possibility arises that the part of the exfoliated film adheres, as a foreign matter, onto the substrate (shot area on the substrate), and/or enters into and mixes with the liquid LQ during the liquid immersion exposure. If the liquid immersion area LR is formed on the edge of the substrate P, for example, as schematically shown in Fig. 12, while leaving the edge of the substrate P in the defective state, the following possibility arises that a part of the film at the edge of the substrate P is exfoliated during the liquid immersion exposure, and enters into and mixes with the liquid LQ. If the liquid immersion exposure is executed, while the state that any foreign matter is adhered to the edge of the substrate P as it is, the following possibility arises as well that, for example, the foreign matter adheres to the shot area on the substrate, and/or the liquid LQ of the liquid immersion area LR is polluted with the foreign matter. If the substrate is exposed in a state that the foreign matter is present, the following possibility arises. That is, any inconvenience occurs, for example, such that any defect appears in the pattern formed on the substrate, and the produced device may be defective. If such a defective device is produced, the throughput in the device production is consequently lowered. If the substrate P is subjected to the liquid immersion exposure in the state that the foreign matter is present, the following possibility arises that the foreign matter present in the liquid LQ adheres to any member which makes contact with the liquid LQ of the liquid immersion area LR, the member including, for example, the nozzle member 6, a part of the substrate stage 4, or the final optical element FL; and that the foreign matter affects the exposure to be performed thereafter as well. There is also a possibility that the coating state of at least one of the first film Rg and the second film Tc is defective at the edge of the substrate P. For example, if the liquid immersion area LR is formed on the edge of the substrate P as schematically shown in Fig. 12, while leaving the coating state of the second film Tc as the liquid-repellent film in the defective state at the edge of the substrate P, then the following possibility arises that, for example, the edge of the second film Tc in which the coating state is defective is exfoliated; that the first film Rg, which is a layer under the second film Tc, makes contact with the liquid LQ, causing the exfoliation of the first film Rg; and that any constitutive substance (for example, PAG and quencher) of the first film Rg is eluted to cause the cloudiness on the liquid contact surface of the final optical element FL. Further, there is a possibility that the liquid LQ inflows into a gap between the upper surface of the substrate P and the upper surface 4F of the substrate stage 4, and the liquid LQ inflows into the back surface side of the substrate P. If the liquid LQ inflows into the back surface side of the substrate P, the following possibility arises that, for example, the inflowed liquid wets the substrate holder 4H; that the substrate P cannot be held smoothly; and/or that the substrate P cannot be unloaded from the substrate holder 4H smoothly. There is also a possibility that the transport device H, which makes contact with the back surface of the substrate P, is wetted as well. In particular, if the liquid leakage is once caused, a situation occurs such that the operation of the exposure apparatus is inevitably stopped, which results in not only the decrease in the throughput but also the failure or disorder of the exposure apparatus itself. That is, the problems, which are caused by the liquid leakage as described above, are inherent in the liquid immersion exposure apparatus.

In this embodiment, the state of the edge of the substrate P is detected before the liquid immersion area LR of the liquid LQ is formed on at least a part of the surface of the substrate P. Accordingly, if the state of the edge is defective, it is possible to adopt the appropriate measure, for example, such that the substrate P is transported, for example, to the coater/developer apparatus C/D, instead of arranging the substrate P in the first area SP1 of the exposure station ST1. In such a case, the liquid immersion area LR is not formed on the substrate P, because the substrate P is not arranged in the exposure station ST1. Therefore, it is possible to suppress the occurrence of the inconvenience as described above, and it is possible to suppress the decrease in the throughput in device production.

### Fourth Embodiment

Next, a fourth embodiment will be explained. The fourth embodiment is a modification of the third embodiment. The feature of an exposure apparatus EX of the fourth embodiment, which is different from that of the third embodiment, is that the exposure apparatus EX is provided with a plurality of substrate stages which are movable independently from each other in a predetermined area on the base member BP. In the following description, the constitutive parts or components, which are the same as or equivalent to those of the embodiment described above, are designated by the same reference numerals, any explanation of which will be simplified or omitted.

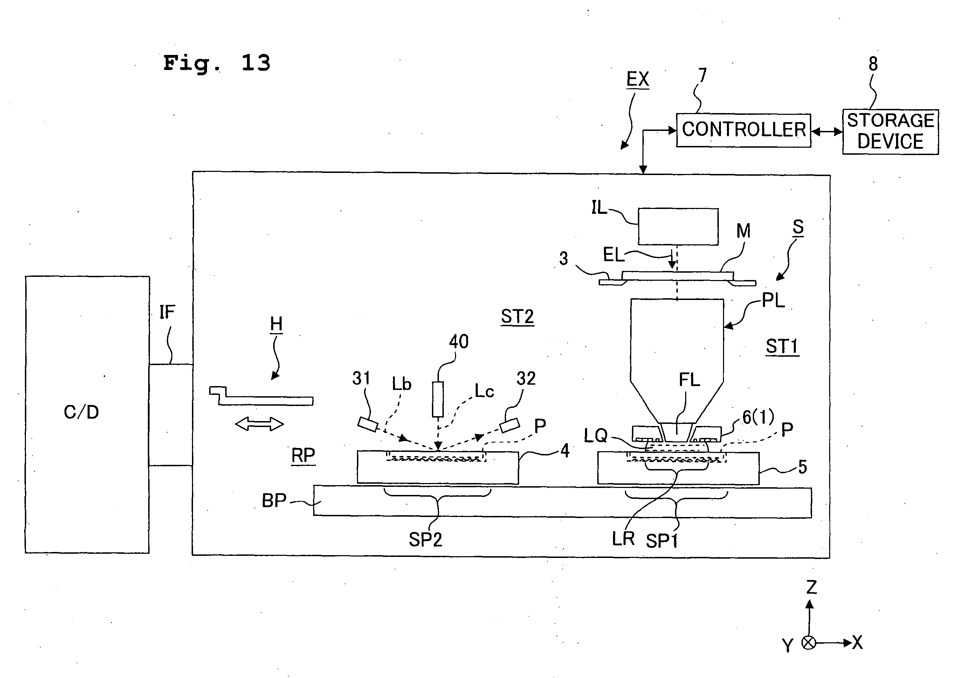

Fig. 13 is a schematic arrangement view of the exposure apparatus EX according to the fourth embodiment. The exposure apparatus EX of this embodiment is an exposure apparatus of the multi-stage (twin-stage) type provided with a plurality of substrate stages movable while holding the substrates, as disclosed, for example, in Japanese Patent Application Laid-open Nos. 10-163099 and 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), Published Japanese Translation of PCT International Publication for Patent Application No. 2000-511704, Japanese Patent Application Laid-open No. 2000-323404, Published Japanese Translation of PCT International Publication for Patent Application No. 2001-513267, and Japanese Patent Application Laid-open No. 2002-158168. The contents of the above-identified United States Patents are incorporated herein by reference within a range of permission of the domestic laws and ordinances of the designated state or the selected state.

With reference to Fig. 13, the exposure apparatus EX of this embodiment is provided with the two substrate stages 4, 5 which are movable while holding the substrates P. The exposure apparatus EX of this embodiment is also provided with the exposure station ST1 which includes the first area SP1 in which the exposure light EL from the projection optical system PL can be irradiated, and the measuring station ST2 which includes the second area SP2 in which the detecting lights Lb from the detecting systems 30, 40 can be irradiated, in the same manner as in the third embodiment described above. The first substrate stage 4 is movable while holding the substrate P in a predetermined area on the base member BP including the first area SP1 of the exposure station ST1 and the second area SP2 of the measuring station ST2. The second substrate stage 5 is movable while holding the substrate P independently from the first substrate stage 4 in the predetermined area on the base member BP including the first area SP1 and the second area SP2. In this embodiment, the first substrate stage 4 and the second substrate stage 5 are constructed substantially equivalently to each other.

In this embodiment, for example, when the first substrate stage 4 is arranged in the second area SP2 of the measuring station ST2, the second substrate stage 5 is arranged in the first area SP1 of the exposure station ST1.

In this embodiment, the detection using the focus/leveling-detecting system 30 and the detection using the mark-detecting system 40 are executed in the second area SP2 of the measuring station ST2 concurrently with at least a part of the exposure for the substrate P held by the second substrate stage 5 in the first area SP1 of the exposure station ST1. The detection using the focus/leveling-detecting system 30 and the detection using the mark-detecting system 40 in the measuring station ST2 include the detection of at least one of the state of the film of the substrate P and the state of the edge of the substrate P and the detection of the position information about the substrate P, in the same manner as in the embodiment described above. That is, the detection using the focus/leveling-detecting system 30 in the measuring station ST2 includes at least one of the detection of the state of formation of the thin film on the substrate P and the detection of the surface position information about the surface of the substrate P (position information in relation to the Z axis, θX, and θY directions). The detection using the mark-detecting system 40 in the measuring station ST2 includes the detection of the state of the edge of the substrate P and the detection of the alignment information of the substrate P (position information in the X, Y, and θZ directions of the plurality of shot areas on the substrate P).

For example, the controller 7 arranges the first substrate stage 4 at the substrate exchange position RP of the measuring station ST2, and a substrate P, which is to be subjected to the exposure process, is loaded on the first substrate stage 4 by using the transport device H. The controller 7 starts the process in relation to the substrate P held by the first substrate stage 4 in the same manner as in the third embodiment in the measuring station ST2. On the other hand, concurrently with the process performed in the measuring station ST2, the exposure is started in the exposure station ST1 for another substrate P which is held by the second substrate stage 5 and which has been subjected to the measurement process in the measuring station ST2.

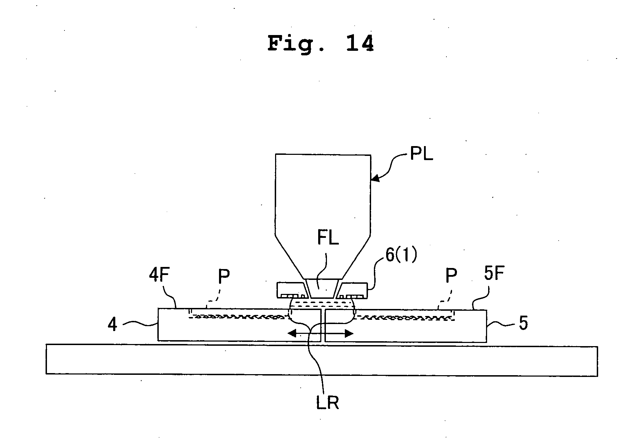

When the process in the exposure station ST1 and the process in the measuring station ST2 are completed respectively, then the controller 7 moves the second substrate stage 5 to the measuring station ST2, and the controller 7 moves the first substrate stage 4 to the exposure station ST1. In this embodiment, when the second substrate stage 5 is moved to the measuring station ST2 and the first substrate stage 4 is moved to the exposure station ST1, then the controller 7 moves the liquid immersion area LR from the surface of the second substrate stage 5 to the surface of the first substrate stage 4 in a state that the liquid immersion area LR is continuously formed. As schematically shown in Fig. 14, for example, the controller 7 moves the substrate stage 4 and the measuring stage 5 together in the XY plane in a state that an upper surface 4F of the substrate stage 4 and an upper surface 5F of the measuring stage 5 are close to each other or make contact with each other in a predetermined area including a position opposite to or facing the lower surface of the final optical element FL (position just under or below the projection optical system PL), thereby making it possible to move the liquid immersion area LR, formed by the liquid immersion mechanism 1, between the upper surface 4F of the substrate stage 4 and the upper surface 5F of the measuring stage 5.

After moving the second substrate stage 5 holding the exposed substrate P to the measuring station ST2, the controller 7 uses the transport device H to unload the substrate P disposed on the second substrate stage 5. Further, another substrate P, which is to be exposed next, is loaded on the second substrate stage 5 in the measuring station ST2, and the measurement process is performed by using the focus/leveling-detecting system 30 and the mark-detecting system 40 as described above.

On the other hand, after moving the first substrate stage 4 holding yet another substrate P for which the measurement process has been performed in the measuring station ST2 to the exposure station ST1, the controller 7 performs the liquid immersion exposure for the yet another substrate P held by the first substrate stage 4 in the exposure station ST1, in the same manner as in the third embodiment described above.

After completing the liquid immersion exposure process for the yet another substrate P on the first substrate stage 4, the controller 7 moves the first substrate stage 4 disposed in the exposure station ST1 to the measuring station ST2, and the second substrate stage 5, which holds the another substrate P for which the measurement process has been performed in the measuring station ST2, is moved to the exposure station ST1.

In this way, the first substrate stage 4 and the second substrate stage 5 are alternately introduced into the exposure station ST1, and a plurality of substrates P are successively exposed.

As explained above, also in this embodiment, at least one of the state of formation of the thin film on the substrate P and the state of the edge of the substrate P is detected before the liquid immersion area LR of the liquid LQ is formed on at least a part of the surface of the substrate P. Therefore, if at least one of the state of formation the thin film and the state of the edge is defective, it is possible to adopt the appropriate measure, for example, such that the substrate P is transported, for example, to the coater/developer apparatus C/D, rather than arranging the substrate P in the first area SP1 of the exposure station ST1. Since the substrate P is not arranged in the exposure station ST1, the liquid immersion area LR is not formed on the substrate P as well. Therefore, it is possible to suppress the decrease in the throughput in producing the device, in the same manner as in the embodiment described above.

In the third and forth embodiments described above, the state of the edge of the substrate P can be detected also by using the focus/leveling-detecting system 30. The state of formation of the thin film on the substrate P can be detected also by using the mark-detecting system 40. Any one of the focus/leveling-detecting system 30 and the mark-detecting system 40 may be provided in the exposure station ST1.

In the third and forth embodiments described above, the focus/leveling-detecting system 30 is also used for the detection of the state of formation of the thin film of the substrate P (and/or the state of the edge of the substrate P), and the mark-detecting system 40 is also used for the detection of the state of the edge (and/or the state of formation of the thin film of the substrate P). However, any detecting system, dedicated for the detection of the state of formation of the thin film of the substrate P and/or the state of the edge of the substrate P, may be separately provided for the measuring station ST2.

In the third and forth embodiments described above, although both of the detection of the state of formation of the thin film of the substrate P and the detection of the edge state of the substrate P are executed, it is also allowable to perform any one of the detections.

In the first embodiment described above, the detector 60 may be used to detect the state of the edge of the substrate P as well. In the first embodiment described above, a detector or detecting device, which detects the state of the edge of the substrate P held by the temperature-adjusting holder 51, may be provided separately from the detector 60. In this case, the detector for detecting the state of the edge of the substrate P may be constructed similarly to the mark-detecting system 40 in the third and fourth embodiments described above. In the first embodiment described above, it is also allowable that only the state of the edge of the substrate P is detected.

In the second embodiment described above, the state of the edge of the substrate P may be detected by using the focus/leveling-detecting system 30. Also in this case, both of the detection of the state of formation of the thin film of the substrate P and the detection of the state of the edge of the substrate P may be executed, or only any one of the detections may be performed.

### Fifth Embodiment

Next, a fifth embodiment will be explained. The feature of this embodiment is that the state of the edge of the substrate P is detected before the substrate P is held by the substrate stage 4. In the following description, the constitutive parts or components, which are the same as or equivalent to those of the embodiment described above, are designated by the same reference numerals, any explanation of which will be simplified or omitted.

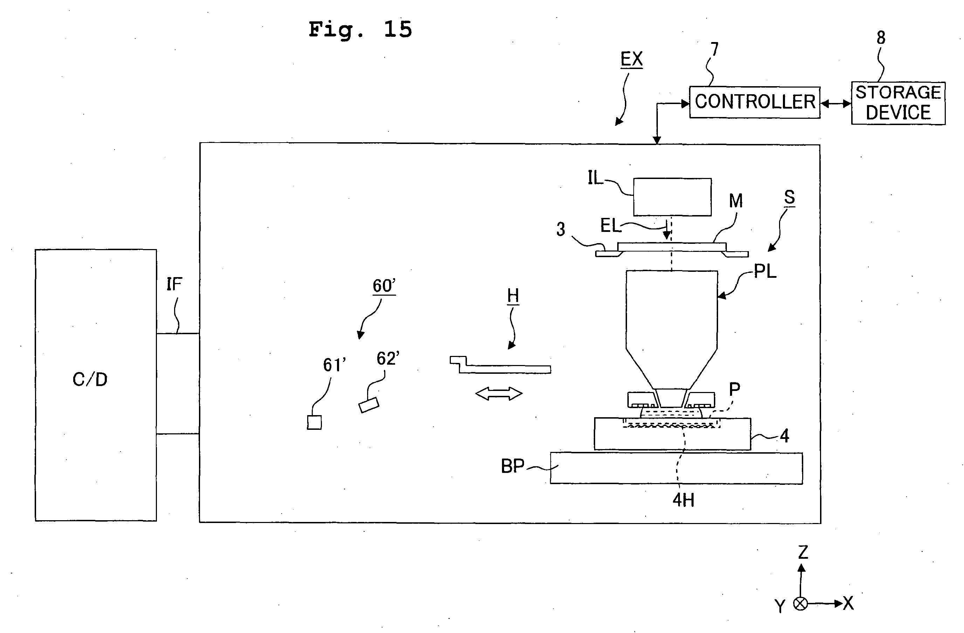

Fig. 15 is a schematic arrangement view of an exposure apparatus EX according to the fifth embodiment. With reference to Fig. 15, the exposure apparatus EX is provided with a detector 60' which detects the state of the edge of the substrate P. The detector 60' detects the state of the edge of the substrate P after the substrate P has been loaded into the exposure apparatus EX from the coater/developer apparatus C/D (coating device) and before the substrate P is held by the substrate stage 4. The exposure apparatus EX is provided with the transport device H which transports the substrate P in the same manner as in the embodiment described above. The transport device H is capable of transporting the substrate P from the coater/developer apparatus C/D to the substrate stage 4. The detector 60' is provided on the transport path of the transport device H.

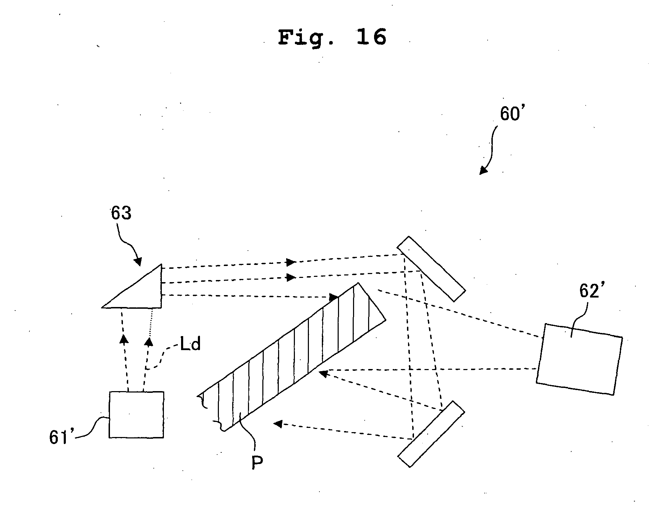

Fig. 16 schematically shows the detector 60'. The detector 60' includes a radiating device 61' which radiates a detecting light Ld different from the exposure light EL, and an image pickup device 62' which obtains an optical image (image) of an objective illuminated with the detecting light Ld from the radiating device 61'. In the detector 60' of this embodiment, the edge of the substrate P is illuminated with the detecting light Ld in a state that the substrate P is inclined with respect to the detecting light Ld such as an infrared laser beam, and the image of the edge illuminated with the detecting light Ld is obtained by the image pickup device 62', as disclosed, for example, in Japanese Patent Application Laid-open No. 2000-136916 (corresponding to European Patent No. 1,001,460). In this embodiment, the detector 60' has an optical system 63 including, for example, a prism which guides the detecting light Ld radiated from the radiating device 61' to the edge of the substrate P. At least one of the detecting light Ld transmitted through the edge of the substrate P and the detecting light Ld reflected by the edge of the substrate P comes into the image pickup device 62'. The detection result of the detector 60' is outputted to the controller 7.

The controller 7 judges or determines whether or not the state of the edge of the substrate P is the desired state, based on the detection result of the detector 60'. As described above, the state of the edge of the substrate P includes at least one of the state of formation of the thin film at the edge of the substrate P and the state of the presence or absence of the foreign matter at the edge of the substrate P.

If the controller 7 judges that the state of the edge of the substrate P is the defective state based on the detection result of the detector 60', then the controller 7 uses the transport device H to transport the substrate P to a predetermined position. For example, if the controller 7 judges that the state of the edge of the substrate P is the defective state, then the controller 7 uses the transport device H to transport the substrate P, for example, to the coater/developer apparatus C/D. Alternatively, the controller 7 uses the transport device H to withdraw the substrate P to a predetermined withdrawal position. On the other hand, if the controller 7 judges that the state of the edge of the substrate P is the desired state based on the detection result of the detector 60', then the controller 7 uses the transport device H to transport the substrate P to the substrate stage 4. The substrate stage 4 holds the substrate P transported from the transport device H. The controller 7 forms the liquid immersion area LR on the substrate P held by the substrate stage 4 and stars the liquid immersion exposure for the substrate P.

As explained above, also in this embodiment, the state of the edge of the substrate P is detected before the liquid immersion area LR of the liquid LQ is formed on at least a part of the surface of the substrate P. Therefore, if the state of the edge is defective, it is possible to adopt the appropriate measure, for example, such that the substrate P is transported, for example, to the coater/developer apparatus C/D, rather than transporting the substrate P to the substrate stage 4. Since the substrate P is not transported to the substrate stage 4, the liquid immersion area LR is not formed on the substrate P as well. Therefore, it is possible to suppress the decrease in the throughput in producing the device in the same manner as in the embodiment described above.

The detector 60', which has been explained with reference to Fig. 16 in this embodiment, may be applied to each of the embodiments described above to detect the state of the edge of the substrate P.

In each of the embodiments described above, at least one of the state of formation of the thin film on the substrate P and the state of the edge of the substrate P may be detected by using a macro-inspecting device as disclosed, for example, in Japanese Patent Application Laid-open No. 2002-195956. When the macro-inspecting device is provided, for example, on the transport path of the transport device H, it is possible to detect at least one of the state of the film on the substrate P and the state of the edge of the substrate P before the substrate P is held by the substrate stage 4 or after the substrate P is held by the substrate stage but before the liquid immersion area LR of the liquid LQ is formed on at least a part of the surface of the substrate P.

In each of the embodiments described above, the state of formation of the second film Tc on the substrate P is detected. However, the second film Tc on the substrate P may be omitted. When the second film Tc is not formed on the substrate P, the detector detects the state of formation of the first film Rg. The controller 7 can adopt an appropriate measure to suppress the decrease in the throughput in producing the device by using the detection result.

In each of the embodiments described above, the explanation has been made as exemplified by the top coat film as the second film Tc which has the function to protect the first film Rg made of the photosensitive material. However, it is also allowable to use a film having any other function such as an antireflection film. In each of the embodiments described above, the explanation has been made such that the films of two layers, i.e., the first film and the second film are formed on the base material W. However, it is of course allowable that a film of one layer is formed, or films of three or more layers are formed. The controller 7 can adopt an appropriate measure to suppress the decrease in the throughput in producing the device by using the detection result in which the state of formation of the film or films on the substrate P is detected.

In each of the embodiments described above, the thin film, which is formed on the substrate P, is formed by the coating process using the coating device, and the detector detects the coating state of the thin film. However, the thin film on the substrate P may be formed by any technique other than the coating. For example, in some cases, an antireflection film is formed by the technique including, for example, the CVD method and the PVD method. However, the detector of each of the embodiments described above can also detect the state of formation of the thin film formed by the technique such as the CVD method and the PVD method. Even in the case that the thin film is formed by the technique other than the coating (application) as described above, the detector can detect the state of formation of the thin film.

In each of the embodiments described above, the state of the film on the substrate P and/or the state of the edge of the substrate P is detected before the liquid immersion area LR of the liquid LQ is formed on at least a part of the surface of the substrate P. However, before the substrate P is loaded into the substrate stage 4, the inspection may be executed in a state that the liquid is supplied onto the thin film of the substrate P. Such an inspection can be performed at any arbitrary place provided that the place is located at the outside of the substrate stage. The inspection may be performed, for example, in the exposure-apparatus body S, in the temperature-adjusting holder in the exposure apparatus EX, on the transport holder, or in the coater/developer apparatus C/D. In this case, since it is possible to previously create the state that the liquid immersion area LR of the liquid LQ is formed, the film in the liquid immersion state can be inspected. In particular, an advantage is obtained such that it is possible to judge whether or not the film is in a satisfactory state for the liquid immersion exposure by directly observing the physical contact state between the liquid and the film including, for example, the contact angle of the liquid.

In each of the embodiments described above, the explanation has been made as exemplified by the case that the liquid immersion exposure apparatus is used to expose the substrate P through the liquid LQ of the liquid immersion area LR formed on the substrate P. However, the detector for detecting the state of formation of the thin film on the substrate can be also provided for any ordinary dry type exposure apparatus in which the substrate is exposed via the gas, without filling the optical path space for the exposure light EL with the liquid.

As described above, pure or purified water is used as the liquid LQ in each of the embodiments described above. Pure water is advantageous in that pure water is available in a large amount with ease, for example, in a semiconductor production factory, and pure water scarcely exerts any harmful influence, for example, on the optical element (lens) and the photosensitive material on the substrate P. Further, pure water exerts no harmful influence on the environment, and the content of impurity is extremely low. Therefore, it is also expected to obtain the function to wash or clean the surface of the substrate P and the surface of the optical element provided at the end portion of the projection optical system PL.

It is approved that the refractive index n of pure water (water) with respect to the exposure light EL having a wavelength of about 193 nm is approximately 1.44. When the ArF excimer laser beam (wavelength: 193 nm) is used as the light source of the exposure light EL, then the wavelength is shortened on the substrate P by 1/n, i.e., to about 134 nm, and a high resolution is obtained. Further, the depth of focus is magnified about n times, i.e., about 1.44 times as compared with the value obtained in the air. Therefore, when it is enough to secure an approximately equivalent depth of focus as compared with the case of the use in the air, it is possible to further increase the numerical aperture of the projection optical system PL. Also in this viewpoint, the resolution is improved.

In each of the embodiments described above, the optical element FL is attached to the end portion of the projection optical system PL. The optical element makes it possible to adjust the optical characteristics of the projection optical system PL, for example, the aberration (for example, spherical aberration and coma aberration). The optical element, which is attached to the end portion of the projection optical system PL, may be an optical plate which is usable to adjust the optical characteristics of the projection optical system PL. Alternatively, the optical element may be a plane-parallel through which the exposure light EL is transmissive.

When the pressure, which is generated by the flow of the liquid LQ, is large between the substrate P and the optical element disposed at the end portion of the projection optical system PL, it is also allowable that the optical element is tightly fixed so that the optical element is not moved by the pressure, instead of making the optical element be exchangeable.

In the case of the projection optical system according to the embodiments described above, the optical path space, on the side of the image plane (light exit surface) of the optical element arranged at the end portion (final optical element FL), is filled with the liquid. However, it is also possible to adopt such a projection optical system that the optical path space, on the side of the object plane (light incident surface) of the optical element arranged at the end portion, is also filled with the liquid, as disclosed, for example, in International Publication No. 2004/019128.

The liquid LQ is water in each of the embodiments described above. However, the liquid LQ may be any liquid other than water. For example, when the light source of the exposure light EL is the F₂ laser, the F₂ laser beam is not transmitted through water. Therefore, liquids preferably usable as the liquid LQ may include, for example, fluorine-based fluids such as fluorine-based oil and perfluoropolyether (PFPE) through which the F₂ laser beam is transmissive. In this case, a portion or part, which makes contact with the liquid LQ, is subjected to a liquid-attracting treatment by forming, for example, a thin film with a substance, including fluorine, which has a molecular structure with small polarity. Alternatively, other than the above, it is also possible to use, as the liquid LQ, liquids (for example, cedar oil) which have the transmittance with respect to the exposure light EL, which have the refractive index as high as possible, and which are stable against the photoresist coated on the surface of the substrate P and the projection optical system PL.

Liquids having refractive indexes of about 1.6 to 1.8 may be used as the liquid LQ. Further, the optical element (for example, the final optical element FL) of the projection optical system PL which makes contact with the liquid LQ may be formed of a material having a refractive index higher than those of silica glass and calcium fluoride (for example, not less than 1.6). It is also possible to use, as the liquid LQ, various liquids including, for example, supercritical liquids. In each of the embodiments described above, the interferometer systems (3L, 4L) are used to measure the position information about the mask stage 3 and the substrate stage 4 respectively. However, the measurements are not limited to this. For example, it is also allowable to use an encoder system which detects the scale (diffraction grating) provided for each of the stages. In this case, it is preferable that a hybrid system including both of the interferometer system and the encoder system is provided, and the measurement result of the encoder system is calibrated (subjected to the calibration) by using the measurement result of the interferometer system. The position control of the stage may be performed by switchingly using the interferometer system and the encoder system or by using both of them.

The substrate P, which is usable in each of the embodiments described above, is not limited to the semiconductor wafer for producing the semiconductor device. Substrates applicable include, for example, a glass substrate for the display device, a ceramic wafer for the thin film magnetic head, and a master plate (synthetic silica glass, silicon wafer) for the mask or the reticle to be used for the exposure apparatus.

As for the exposure apparatus EX, the present invention is also applicable to a scanning type exposure apparatus (scanning stepper) of the step-and-scan system which performs the scanning exposure with the pattern of the mask M by synchronously moving the mask M and the substrate P, as well as to a projection exposure apparatus (stepper) of the step-and-repeat system which performs the full field exposure with the pattern of the mask M in a state that the mask M and the substrate P are allowed to stand still, while successively step-moving the substrate P.

Further, in the exposure of the step-and-repeat system, a reduction image of a first pattern may be transferred onto the substrate P by using the projection optical system in a state that the first pattern and the substrate P are allowed to substantially stand still, and then the full field exposure may be performed on the substrate P by partially overlaying a reduction image of a second pattern with respect to the first pattern by using the projection optical system in a state that the second pattern and the substrate P are allowed to substantially stand still (full field exposure apparatus of the stitch system). As for the exposure apparatus of the stitch system, the present invention is also applicable to an exposure apparatus of the step-and-stitch system in which at least two patterns are partially overlaid and transferred onto the substrate P, and the substrate P is successively moved.

In the fourth embodiment, the explanation has been made about the exposure apparatus of the multi-stage (twin-stage) type in which the two substrate stages are moved between the exposure station and the measuring station. However, a plurality of substrate stages may be adopted for the exposure apparatus of the embodiments other than the fourth embodiment.

Further, the present invention is also applicable to the exposure apparatus provided with a substrate stage which holds the substrate and a measuring stage which has a reference member including a reference mark formed therein and/or various photoelectric sensors as disclosed, for example, in Japanese Patent Application Laid-open No. 11-135400 (corresponding to International Publication No. 1999/23692) and Japanese Patent Application Laid-open No. 2000-164504 (corresponding to United States Patent No. 6, 897, 963).

In the embodiments described above, the exposure apparatus is adopted, in which the space between the projection optical system PL and the substrate P is locally filled with the liquid. However, the present invention is also applicable to a liquid immersion exposure apparatus which performs the exposure in a state that the entire surface of the substrate as the exposure objective is immersed in the liquid, as disclosed, for example, in Japanese Patent Application Laid-open Nos. 6-124873 and 10-303114 and United States Patent No. 5,825,043.

The embodiments have been explained as exemplified by the exposure apparatus provided with the projection optical system PL by way of example. However, the present invention is applicable to an exposure apparatus and a exposure method in which the projection optical system PL is not used. Even when the projection optical system PL is not used as described above, the exposure light is radiated onto the substrate via an optical member such as a lens, and the liquid immersion area is formed in a predetermined space between such an optical member and the substrate.

As for the type of the exposure apparatus EX, the present invention is not limited to the exposure apparatus for the semiconductor device production which exposes the substrate P with the semiconductor device pattern. The present invention is also widely applicable, for example, to an exposure apparatus for producing the liquid crystal display device or for producing the display as well as an exposure apparatus for producing, for example, the thin film magnetic head, the image pickup device (CCD), the micromachine, MEMS, the DNA chip, the reticle, or the mask.

In the embodiments described above, the light-transmissive type mask is used, in which the predetermined light-shielding pattern (or phase pattern or dimming or light-reducing pattern) is formed on the light-transmissive substrate. However, in place of such a mask, as disclosed, for example, in United States Patent No. 6,778,257, it is also allowable to use an electronic mask on which a transmissive pattern, a reflective pattern, or a light-emitting pattern is formed based on the electronic data of the pattern to be subjected to the exposure (also referred to as "variable shaped mask" including, for example, DMD (Digital Micro-mirror Device) that is one of the non-light emission type image display device (spatial image modulator)).

The present invention is also applicable to an exposure apparatus (lithography system) in which the substrate P is exposed with a line-and-space pattern by forming interference fringes on the substrate P as disclosed, for example, in International Publication No. 2001/035168. Further, the present invention is also applicable, for example, to an exposure apparatus in which patterns of two masks are combined on the substrate via the projection optical system, and one shot area on the substrate is subjected to the double exposure substantially simultaneously by performing the scanning exposure one time as disclosed, for example, in Published Japanese Translation of PCT International Publication for Patent Application No. 2004-519850 (corresponding to United States Patent No. 6,611,316).

As described above, the exposure apparatus EX according to the embodiment of the present invention is produced by assembling the various subsystems including the respective constitutive elements as defined in claims so that the predetermined mechanical accuracy, electric accuracy and optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which the temperature, the cleanness and the like are managed.

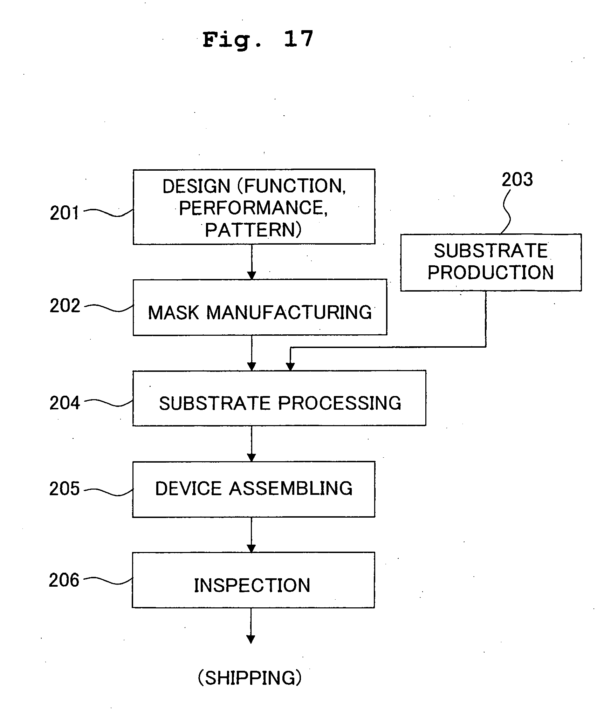

As shown in Fig. 17, a microdevice such as the semiconductor device is produced by performing, for example, a step 201 of designing the function and the performance of the microdevice, a step 202 of manufacturing a mask (reticle) based on the designing step, a step 203 of producing a substrate as a base material for the device, a substrate-processing step 204 including the substrate processing (exposure process) for forming a thin film on the substrate, detecting and evaluating the state of the thin film, exposing the substrate with the pattern of the mask, and developing the exposed substrate in accordance with the embodiment as described above, a step 205 of assembling the device (including a dicing step, a bonding step, and a packaging step), and an inspection step 206.

### INDUSTRIAL APPLICABILITY

According to the present invention, it is possible to satisfactorily expose the substrate, and it is possible to suppress the decrease in the throughput in producing the device. In particular, the liquid immersion exposure apparatus, which exposes the substrate through the liquid, can be prevented from any failure or disorder beforehand, and a device having a high density circuit pattern can be produced at a high throughput. Therefore, the present invention will contribute to the development of the IT industry and the high technology industry including the semiconductor industry in our country.

## Claims

1. An exposure apparatus which exposes a substrate by radiating an exposure light onto the substrate on which a thin film is formed, the exposure apparatus comprising a detector which detects a state of formation of the thin film on the substrate.

2. The exposure apparatus according to claim 1,
wherein the thin film is formed by coating a predetermined material on the substrate; and
the detector detects a coating state of the thin film.

3. The exposure apparatus according to claim 1, further comprising:
a liquid immersion mechanism which forms a liquid immersion area of a liquid on the substrate,
wherein the exposure light is radiated onto the substrate through the liquid of the liquid immersion area.

4. The exposure apparatus according to claim 3,
wherein the detector detects the state of formation of the thin film before the liquid immersion area is formed on the substrate.

5. The exposure apparatus according to claim 3,
wherein the thin film includes a liquid-repellent film.

6. The exposure apparatus according to claim 1,
wherein the detector optically detects the state of formation of the thin film.

7. The exposure apparatus according to claim 1,
wherein the detector has a light-emitting system which emits a detecting light onto the substrate, and a light-receiving system which is capable of receiving the detecting light via the substrate.

8. The exposure apparatus according to claim 7, further comprising:
a storage device which previously stores a relationship between the state of formation of the thin film and a light-receiving state of the light-receiving system; and
a judging device which judges whether or not the state of formation of the thin film is a desired state, based on the relationship stored in the storage device and on a light-receiving result of the light-receiving system.

9. The exposure apparatus according to claim 1, further comprising:
a holding member which holds the substrate which is irradiated with the exposure light; and
a transport device which is capable of transporting the substrate to the holding member,
wherein the detector is provided on a transport path of the transport device.

10. The exposure apparatus according to claim 9, further comprising a controller which controls operation of the transport device based on a result of detection performed by the detector.

11. The exposure apparatus according to claim 9, further comprising a process device which is provided on the transport path of the transport device and which processes the substrate,
wherein the detector detects the state of formation of the thin film of the substrate loaded into the process unit.

12. The exposure apparatus according to claim 1, further comprising a holding member which holds the substrate which is irradiated with the exposure light,
wherein the detector detects the state of formation of the thin film on the substrate in a state that the substrate is held by the holding member.

13. The exposure apparatus according to any one of claims 1 to 12, wherein the detector detects the state of formation of the thin film at an edge of the substrate.

14. The exposure apparatus according to claim 1,
wherein the detection of the state of formation of the thin film is detection of presence of the thin film.

15. An exposure apparatus which exposes a substrate by radiating an exposure light onto the substrate through a liquid, the exposure apparatus comprising a detector which detects a state of an edge of the substrate.

16. The exposure apparatus according to claim 15,
wherein the detector detects a state of formation of a thin film at the edge of the substrate.

17. The exposure apparatus according to claim 16,
wherein the thin film is formed by coating a predetermined material on the substrate; and
the detector detects a coating state of the thin film at the edge of the substrate.

18. The exposure apparatus according to claim 16,
wherein the thin film includes a liquid-repellent film.

19. The exposure apparatus according to claim 15,
wherein the detector detects whether or not foreign matter is present at the edge of the substrate.

20. The exposure apparatus according to claim 15,
wherein the detector detects the state of the edge before a liquid immersion area of the liquid is formed on at least a part of the substrate.

21. The exposure apparatus according to claim 20, further comprising a substrate-holding member capable of holding the substrate at a position at which the exposure light can be irradiated,
wherein the detector detects the state of the edge before the substrate is held by the substrate-holding member.

22. The exposure apparatus according to claim 21, further comprising a transport device which is capable of transporting the substrate to the substrate-holding member,
wherein the detector is provided on a transport path of the transport device.

23. The exposure apparatus according to claim 20, further comprising a first substrate-holding member capable of holding the substrate at a position at which the exposure light can be irradiated,
wherein the detector detects the state of the edge after the substrate is held by the first substrate-holding member.

24. The exposure apparatus according to claim 23,
wherein the first substrate-holding member is moved into a first area in which the exposure light can be irradiated after the detector detects the state of the edge of the substrate held by the first substrate-holding member.

25. The exposure apparatus according to claim 23,
wherein the first substrate-holding member is movable while holding the substrate in a predetermined area including a first area in which the exposure light can be irradiated and a second area which is different from the first area; and
the detector detects the state of the edge of the substrate held by the first substrate-holding member in the second area.

26. The exposure apparatus according to claim 25, further comprising a second substrate-holding member which is movable while holding the substrate independently from the first substrate-holding member in the predetermined area,
wherein the second substrate-holding member is arranged in the first area when the first substrate-holding member is arranged in the second area.

27. The exposure apparatus according to claim 26,
wherein the detector detects the state of the edge of the substrate held by the first substrate-holding member in the second area concurrently with at least a part of the exposure performed for another substrate held by the second substrate-holding member in the first area.

28. The exposure apparatus according to claim 27,
wherein position information about the substrate held by the first substrate-holding member is obtained in the second area concurrently with at least a part of the exposure performed for the another substrate held by the second substrate-holding member in the first area.

29. The exposure apparatus according to claim 28,
wherein the detector includes an optical device which obtains the position information.

30. The exposure apparatus according to claim 15,
wherein the detector includes an image pickup device which obtains an optical image of the edge.

31. An exposure apparatus which exposes a substrate by radiating, through a liquid, an exposure light onto the substrate on which a thin film is formed, the exposure apparatus comprising:
an optical system which is arranged in an optical path for the exposure light; and
a detector which detects a defect of the thin film of the substrate to which the liquid is provided.

32. The exposure apparatus according to claim 31,
wherein the defect of the thin film is absence of the thin film.

33. The exposure apparatus according to claim 31,
wherein the defect of the thin film is a defect of the thin film at an edge of the substrate.

34. The exposure apparatus according to claim 31,
wherein the detector detects the defect of the thin film in a state that the liquid is absent on the thin film.

35. The exposure apparatus according to claim 31,
wherein the detector is provided in a transport path via which the substrate is transported to the exposure apparatus.

36. The exposure apparatus according to claim 31, further comprising a temperature-adjusting device which adjusts a temperature of the substrate, wherein the detector is provided for the temperature-adjusting device.

37. The exposure apparatus according to claim 31,
wherein the exposure apparatus has an exposure station and a measuring station, wherein the detector is provided for the measuring station.

38. The exposure apparatus according to claim 37, further comprising a substrate-holding member which is movable between the exposure station and the measuring station while holding the substrate.

39. The exposure apparatus according to claim 31,
wherein the thin film is a photosensitive material or a protective film.

40. A method for producing a device, comprising using the exposure apparatus as defined in any one of claims 1, 15, and 31.

41. A method for processing a substrate, on which a film is formed, for exposure-processing the substrate, the method comprising:
holding the substrate by a substrate-holding member;
radiating an exposure light through a liquid onto the substrate held by the substrate-holding member to exposure-process the substrate; and
detecting a state of the film of the substrate before radiating the exposure light onto the substrate.

42. The method for processing the substrate according to claim 41, wherein the detection of the state of the film of the substrate is executed before the substrate is held by the substrate-holding member.

43. The method for processing the substrate according to claim 41, wherein the detection of the state of the film of the substrate includes detection of the state of the film at an edge of the substrate.

44. The method for processing the substrate according to claim 41, wherein the detection of the state of the film of the substrate includes detection of absence of the film.

45. A method for processing a substrate to be exposed through a liquid, the method comprising:
forming a thin film on the substrate;
inspecting a defect of the thin film;
supplying the liquid onto the thin film; and
radiating an exposure light onto the substrate through the supplied liquid.

46. The method for processing the substrate according to claim 45, wherein the liquid is supplied onto the thin film only when result of the inspection is that the defect of the thin film is absent.

47. The method for processing the substrate according to claim 45, wherein the formation of the thin film, the radiation of the exposure light, and the inspection of the defect of the thin film are performed at mutually different positions.

48. The method for processing the substrate according to claim 45, wherein the defect of the thin film includes absence of the thin film or a defect of the thin film at an edge of the substrate.

49. A method for producing a device, comprising exposure-processing a substrate by using the method for processing the substrate as defined in claim 41 or 45; developing the exposed substrate; and processing the developed substrate.
